# EUROPEAN PATENT APPLICATION

(11) **EP 4 339 702 A1**
(43) Date of publication of application: **20.03.2024**
(21) Application number: 23196567.4
(22) Date of filing: 11.09.2023
(51) Int. Cl.: G03F 7/004, G03F 7/09, G03F 7/40, C07F 7/22

(54) **COMPOUND FOR FORMING METAL-CONTAINING FILM, COMPOSITION FOR FORMING METAL-CONTAINING FILM, PATTERNING PROCESS, AND SEMICONDUCTOR PHOTORESIST MATERIAL**

(30) Priority: 14.09.2022 JP 2022146460; 12.05.2023 JP 2023079240
(71) Applicant: SHIN-ETSU CHEMICAL CO., LTD., Tokyo 1000005 (JP)
(72) Inventor: KOBAYASHI, Naoki, Niigata (JP); IWAMORI, Shohei, Niigata (JP); KORI, Daisuke, Niigata (JP); KIKUCHI, Shun, Niigata (JP)
(74) Representative: Sonnenhauser, Thomas Martin

(57) **Abstract**

A compound for forming a metal-containing film to be contained in a composition for forming a metal-containing film used in manufacturing a semiconductor, where the compound for forming a metal-containing film is represented by the following general formula (M-1) or (M-2). This provides: a compound for forming a metal-containing film having better dry etching resistance than conventional resist underlayer film materials and also having high filling and planarizing properties; a composition for forming a metal-containing film containing the compound; a patterning process in which the composition is used as a resist underlayer film material; a patterning process in which the composition is used as a resist material; and a semiconductor photoresist material containing the composition.

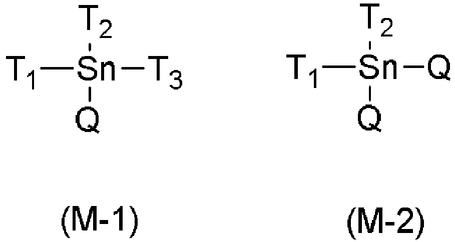

## Description

### TECHNICAL FIELD

The present invention relates to: a compound for forming a metal-containing film; composition for forming a metal-containing film containing the compound; a patterning process using the composition; and a semiconductor photoresist material containing the composition.

### BACKGROUND ART

As LSIs advance toward higher integration and higher processing speed, miniaturization of pattern rule is progressing rapidly. As a cutting-edge technology for miniaturization, ArF immersion lithography has been adopted for mass-producing 45-nm node devices and smaller. In addition to ArF immersion exposure, double exposure (double patterning) processes have been put to practical use in generations of 28-nm node devices and smaller, so that the formation of narrow-pitch patterns that exceed the optical limit has also become possible.

Furthermore, in the production of 20-nm node and smaller devices, studies have been carried out on multiple exposure (multi-patterning) processes for forming a pattern with a narrower pitch by repeating exposure and etching three or more times. However, multiple exposure processes have an increased number of steps, and are faced with the situation that costs rise considerably due to degradation in productivity caused by longer time spent in manufacturing and more frequent generation of defects.

In recent years, vacuum ultraviolet ray (EUV) lithography with a wavelength of 13.5 nm is attracting attention as an effective technology to replace a combination of ArF immersion lithography and multiple exposure process. By using this technology, it has become possible to form a fine pattern with a half pitch of 25 nm or less in one exposure.

Meanwhile, in EUV lithography, resist materials are strongly required to have higher sensitivity to compensate for insufficient output of a light source. However, increase in shot noise accompanying higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element such as barium, titanium, hafnium, zirconium, or tin has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, resist materials with added metal salt or organometallic complex disclosed in Patent Documents 1 and 2 or non-chemically amplified resist materials that use nanoparticles of metal oxide disclosed in Patent Documents 3 and 4 are considered.

In particular, molecules containing tin are excellent in the absorption of an electron beam and an extreme ultraviolet ray, and are actively researched. In the case of an organotin polymer, which is one such molecule, alkyl ligand is dissociated by light absorption or secondary electrons produced thereby and crosslinked with adjacent chains through an oxo bond, and thus enables the negative tone patterning which may not be removed by an organic developing solution. This organic tin polymer can improve sensitivity while maintaining a resolution and line edge roughness, but has not yet reached the standards for commercial availability (Patent Document 5). In addition, many problems still remain, such as insufficient storage stability regarding change in resist sensitivity.

To solve the problems, there is also consideration of development of the use of a material containing a metal element, such as titanium, hafnium, zirconium, and tin, for a resist underlayer film. There is no need for the improvement for performance, such as the enhancement of exposure sensitivity and the suppression of change in sensitivity in storage environment, which are issues in resist materials containing metal. In addition, it may be possible to provide a resist underlayer film excellent in dry etching resistance when the metal element is contained. Patent Document 6 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 6, a metal oxide compound generally has large thermal shrinkage during baking and induces remarkable degradation of filling after baking at a high temperature. Therefore, there is a concern that such a compound is insufficient as a resist underlayer film material for which high planarizing and filling properties and heat resistance are required. Patent Document 7 reports that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases). Patent Document 8 provides a resist underlayer film material excellent in filling property after baking at 400°C by mixing the metal compound reported in Patent Document 7 and an organic polymer having a particular structure. However, since the material is a mixed composition of a metal compound which is inorganic and a polymer which is organic, there are concerns for film formation defects, degradation of storage stability, degradation of dry etching resistance, etc. caused by compatibility failure.

### CITATION LIST

### PATENT LITERATURE

Patent Document 1: JP5708521B2
Patent Document 2: JP5708522B2
Patent Document 3: US9310684B2
Patent Document 4: US2017/0102612A1
Patent Document 5: JP2021-162865A
Patent Document 6: JP6189758B2
Patent Document 7: JP7050137B2
Patent Document 8: JP2022-521531A

### SUMMARY OF INVENTION

### TECHNICAL PROBLEM

The present invention has been made in view of the above-described circumstances. An object of the present invention is to provide: a compound for forming a metal-containing film having better dry etching resistance than conventional resist underlayer film materials and also having high filling and planarizing properties; a composition for forming a metal-containing film containing the compound; a patterning process in which the composition is used as a resist underlayer film material; a patterning process in which the composition is used as a resist material; and a semiconductor photoresist material containing the composition.

### SOLUTION TO PROBLEM

To achieve the object, the present invention provides a compound for forming a metal-containing film to be contained in a composition for forming a metal-containing film used in manufacturing a semiconductor, wherein the compound for forming a metal-containing film is represented by the following general formula (M-1) or (M-2), 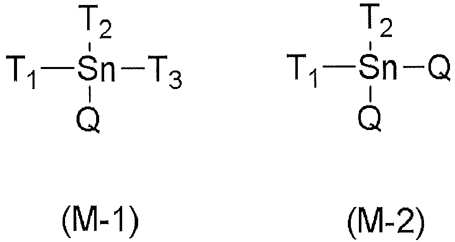 wherein T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 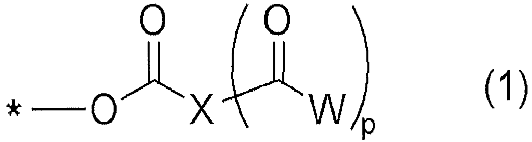 wherein X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom, 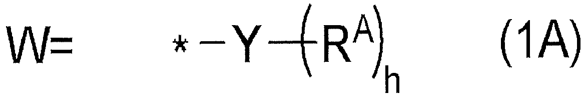 wherein Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point, 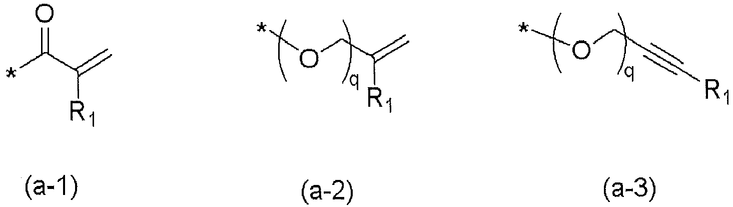 wherein R₁ represents a hydrogen atom or a monovalent organic group having 1 to 10 carbon atoms; "q" represents 0 or 1; and "*" represents an attachment point to Y.

Such a compound for forming a metal-containing film has at least two organic groups shown by the general formula (1), so that the compound for forming a metal-containing film has excellent solvent solubility and excellent heat resistance. In addition, the compound has a hydroxy group or a crosslinking group having a structure shown by one of the general formulae (a-1) to (a-3) at the end, so that when the compound is used in a composition for forming a metal-containing film, volume shrinkage during baking is small. Furthermore, unlike tin-containing compounds for forming a resist upper layer film such as those reported in Patent Document 5, the inventive compound can provide a resist underlayer film material that has excellent film-formability and excellent planarizing and filling properties even after high-temperature baking.

In the present invention, the W in the general formula (1) preferably has a structure represented by the following general formula (1B), 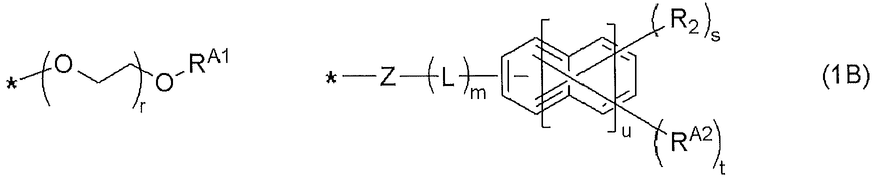 wherein R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "t" represents 1 to 6; "s" represents 0 to 5; t+s is 1 or more and 6 or less; "r" represents 1 to 10; "u" represents 0 or 1; "m"
represents 0 or 1; and "*" represents an attachment point.

When the W has a structure shown by the general formula (1B), thermal flowability of the compound for forming a metal-containing film can be enhanced, so that when the compound is contained in a composition for forming a metal-containing film, it is possible to provide a resist underlayer film material that exhibits better planarizing and filling properties.

In the present invention, the X in the general formula (1) preferably represents an unsaturated hydrocarbon having 2 to 20 carbon atoms.

When the X in the general formula (1) represents an unsaturated hydrocarbon having 2 to 20 carbon atoms, thermosetting property of the compound for forming a metal-containing film can be improved further.

The compound for forming a metal-containing film is preferably represented by the following general formula (2), 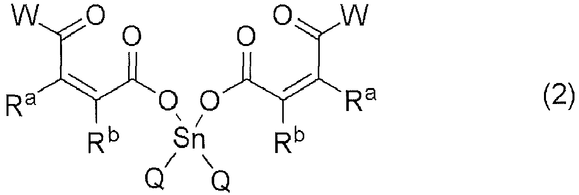 wherein R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto; and Q and W are as defined above.

When the compound for forming a metal-containing film has such a structure, both high thermal flowability and high thermosetting property can be achieved. When such a compound is contained in a composition for forming a metal-containing film, it is possible to provide a resist underlayer film material that exhibits better planarizing and filling properties.

Furthermore, in the present invention, the compound for forming a metal-containing film preferably satisfies 1.00 ≤ Mw/Mn ≤ 1.30, where Mw is a weight-average molecular weight and Mn is a number-average molecular weight measured by gel permeation chromatography in terms of polystyrene.

A compound for forming a metal-containing film having dispersity of such a range has even better thermal flowability, so that when the compound is contained in a composition for forming a metal-containing film, not only is it possible to fill favorably a fine structure formed on a substrate, it is also possible to form a resist underlayer film so that the entire substrate is flat.

The present invention also provides a composition for forming a metal-containing film, the composition functioning as a resist underlayer film material and/or a resist material used in manufacturing a semiconductor, the composition comprising: (A) the above-described compound for forming a metal-containing film; and (B) an organic solvent.

Such a composition for forming a metal-containing film contains an organotin compound excellent in heat resistance and thermal flowability, and therefore, can provide a resist underlayer film material having better dry etching resistance than conventional resist underlayer film materials and also having high filling and planarizing properties. Furthermore, the composition contains tin atoms, which are excellent in absorbance of electron beam and extreme ultraviolet ray, so that when the composition is contained in a resist material, it is possible to provide a resist material having high sensitivity and high resolution particularly in EUV and electron beam lithography.

In the present invention, the composition for forming a metal-containing film may be usable as a resist underlayer film used in a multilayer resist method, and the composition can further comprise one or more of (C) a crosslinking agent, (D) a high-boiling-point solvent, (E) a surfactant, and (F) a flowability accelerator.

When the composition for forming a metal-containing film contains one or more of the above additives, it is possible to obtain a composition for forming a resist underlayer film having better coating property, dry etching resistance, and filling and planarizing properties.

In this event, the high-boiling-point solvent (D) is preferably one or more kinds of organic solvent having a boiling point of 180°C or higher.

By imparting thermal flowability to the compound for forming a metal-containing film by adding a high-boiling-point solvent, the composition for forming a resist underlayer film is provided with both high filling property and high planarizing property.

In the present invention, the composition for forming a metal-containing film can further comprise (G) metal oxide nanoparticles having an average primary particle size of 100 nm or less.

In this event, the metal oxide nanoparticles (G) are preferably selected from the group consisting of zirconium oxide nanoparticles, hafnium oxide nanoparticles, titanium oxide nanoparticles, tin oxide nanoparticles, and tungsten oxide nanoparticles.

When such metal oxide nanoparticles are contained, the metal content in the composition can be increased easily, and the dry etching resistance of the composition for forming a resist underlayer film can be improved further.

The present invention also provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(1-4) transferring the pattern to the metal-containing film by dry etching while using the resist upper layer film having the formed pattern as a mask; and
(1-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the above-described composition for forming a metal-containing film onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with a high degree of accuracy.

The present invention also provides a patterning process for forming a pattern in a substrate to be processed, comprising the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with a high degree of accuracy.

In this event, the inorganic hard mask middle layer film is preferably formed by a CVD method or an ALD method.

When the inorganic hard mask middle layer film is formed by a CVD method or an ALD method, a fine pattern can be formed on a body to be processed with higher accuracy.

The present invention also provides a patterning process for forming a pattern in a substrate to be processed, comprising the steps of:
(IV-1) forming a resist underlayer film on a substrate to be processed;
(IV-2) applying the above-described composition for forming a metal-containing film onto the resist underlayer film, followed by heating to form a metal-containing film;
(IV-3) forming a resist upper layer film on the metal-containing film by using a photoresist material;
(IV-4) subjecting the resist upper layer film to pattern exposure and then development with a developer to form a pattern in the resist upper layer film;
(IV-5) transferring the pattern to the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

The patterning process by way of the multilayer resist process makes it possible to form fine patterns on the body to be processed with a high degree of accuracy.

The present invention also provides a patterning process for forming a pattern in a substrate to be processed, comprising the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with a higher degree of accuracy.

The present invention also provides a patterning process comprising the steps of:
applying the above-described composition for forming a metal-containing film onto a substrate, followed by heating to form a resist film;
exposing the resist film to a high-energy beam; and
developing the exposed resist film by using a developer.

According to the inventive patterning processes using the inventive compound for forming a metal-containing film as a semiconductor photoresist material, it is possible to form a pattern having small edge roughness and little residue in a dissolved portion of the resist.

In this event, an organic solvent is preferably used as the developer.

Furthermore, the developer is preferably one or more organic solvents selected from 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.

In the present invention, such a developer can be used suitably.

Furthermore, an extreme ultraviolet ray having a wavelength of 3 to 15 nm or an electron beam having an acceleration voltage of 1 to 250 kV is preferably used as the high-energy beam.

The exposure is preferably carried out under such conditions from viewpoints of sensitivity and resolution.

The present invention also provides a semiconductor photoresist material, wherein the semiconductor photoresist material is the above-described composition for forming a metal-containing film further comprising (H) a photo-acid generator.

Such a resist material is a metal-containing resist material that has high sensitivity and high resolution particularly in EUV and electron beam lithography.

### ADVANTAGEOUS EFFECTS OF INVENTION

As described above, the inventive compound for forming a metal-containing film has at least two organic groups represented by the general formula (1), and therefore, the compound for forming a metal-containing film has excellent solvent solubility and excellent thermal flowability. In addition, since the compound has a hydroxy group or a crosslinking group having a structure represented by one of the general formulae (a-1) to (a-3) at the end, the compound is also excellent in thermosetting property. Therefore, when the compound is used for a composition for forming a resist underlayer film, it is possible to provide a resist underlayer film material whose volume shrinkage at the time of baking is small, the material having excellent film-formability and excellent planarizing and filling properties even after baking at a high temperature.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type organic resist underlayer film materials, and therefore, a fine pattern can be formed on a body to be processed with even higher precision compared with an organic resist underlayer film.

A composition for forming a metal-containing film containing the inventive compound for forming a metal-containing film contains tin atoms, which have high light absorbance, and therefore, has a sensitizing effect caused by secondary electrons generated from the tin atoms during exposure. Furthermore, tin atoms have a great atomic weight, and therefore, have a high effect of suppressing the diffusion of acid from an upper layer resist to a resist underlayer film, and have a characteristic that higher sensitivity can be achieved while sustaining the LWR performance that the resist upper layer film originally has.

Moreover, the inventive compound for forming a metal-containing film contains tin atoms, which have high absorbance of light, and therefore, can also be used for a semiconductor photoresist material. As explained above, the inventive compound for forming a metal-containing film has excellent curability, so that it is possible to provide a metal-containing resist material having high sensitivity and high resolution in EUV and electron beam lithography.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating the filling property.
FIG. 4 is an explanatory view of a method for evaluating the planarizing property.
FIG. 5 is a graph showing the evaluation of electron beam exposure.

### DESCRIPTION OF EMBODIMENTS

As stated above, there have been demands for the development of: a composition for forming a metal-containing film, excellent in filling property and planarization property, used for forming a resist underlayer film that makes it possible to transfer a resist pattern to a substrate to be processed with higher precision in a fine patterning process according to a multilayer resist method; and a compound for forming a metal-containing film useful for the composition.

The present inventors have focused on organotin compounds, which are expected to play an active role in the EUV-exposure generation, and studied earnestly. As stated above, tin atoms, which greatly absorb light, have a sensitizing effect due to secondary electrons generated from the atoms during exposure, and have a characteristic that higher sensitivity can be achieved while maintaining the LWR performance that a resist upper layer film originally has. On the other hand, organotin compounds, which are considered as resist upper layer films, have poor heat resistance, and undergo rapid volume shrinkage during baking. Therefore, it is difficult to fill and planarize the steps of a substrate to be processed after high-temperature baking. The present inventors have considered that when an organic group excellent in heat resistance is contained, rapid volume shrinkage at the time of baking can be reduced and thermal flowability can be improved, so that steps of a substrate to be processed can be filled without voids being generated even after baking at a high temperature. The present inventors have also assumed that a compound for forming a metal-containing film having a structure that contains a crosslinking group at a terminal has excellent thermosetting property during baking, and therefore, has better heat resistance.

The present inventors have studied earnestly further, and found out that a compound for forming a metal-containing film containing at least two organic groups represented by the general formula (1) gives a composition for forming a metal-containing film that can reduce sudden volume shrinkage during baking since the composition has excellent thermosetting property, can realize high filling and planarizing properties since the composition also has favorable thermal flowability, can contribute to the improvement of sensitivity while maintaining the LWR of an upper layer resist since the composition contains tin atoms, and has excellent dry etching resistance since alkyl ligand is dissociated after high-temperature baking and forms SnO₂ by crosslinking with adjacent chains through an oxo bond. The present inventors have also found out that when the compound, which has excellent curability, is used in a resist material, it is possible to provide a metal-containing resist material having high sensitivity and high resolution in EUV and electron beam lithography. Thus, the present invention has been completed.

That is, the present invention is a compound for forming a metal-containing film to be contained in a composition for forming a metal-containing film used in manufacturing a semiconductor, wherein the compound for forming a metal-containing film is represented by the following general formula (M-1) or (M-2), 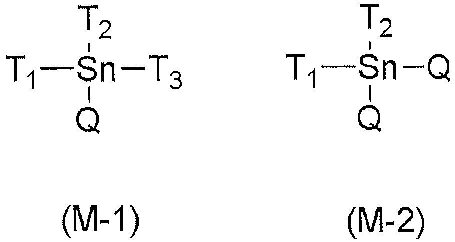 wherein T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 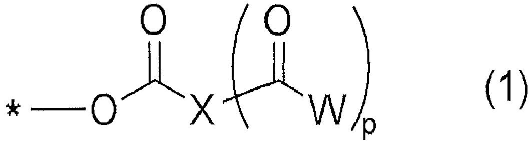 wherein X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom, 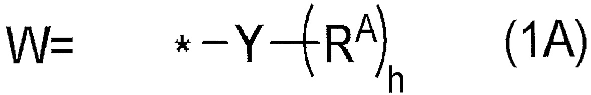 wherein Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point, 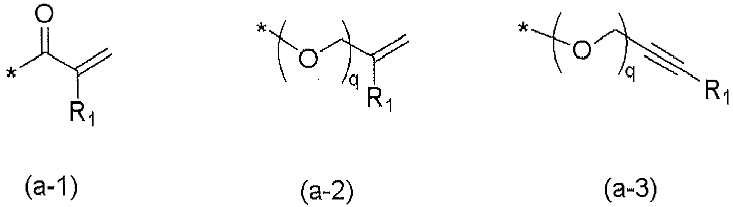 wherein R₁ represents a hydrogen atom or a monovalent organic group having 1 to 10 carbon atoms; "q" represents 0 or 1; and "*" represents an attachment point to Y.

Hereinafter, the present invention will be described in detail, but the present invention is not limited thereto.

### <Compound for Forming Metal-Containing Film>

The inventive compound for forming a metal-containing film is represented by the following general formula (M-1) or (M-2).

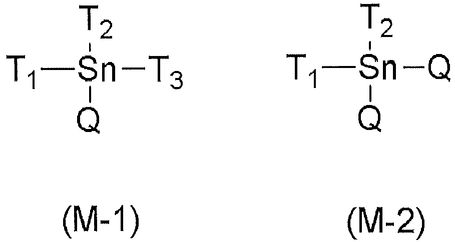

In the general formulae (M-1) and (M-2), T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups.

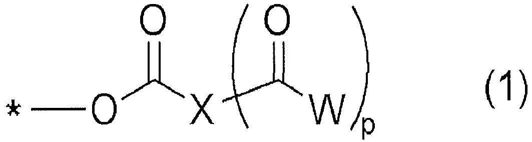

In the general formula (1), X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom.

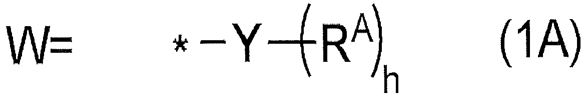

In the general formula (1A), Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point.

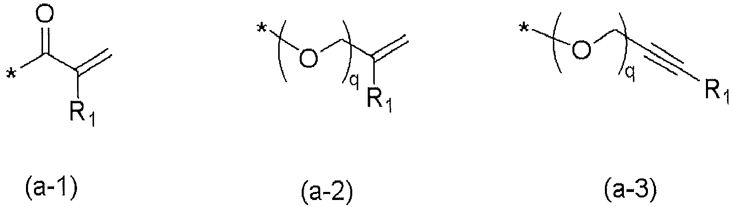

In the general formulae (a-1) to (a-3), R₁ represents a hydrogen atom or a monovalent organic group having 1 to 10 carbon atoms; "q" represents 0 or 1; and "*" represents an attachment point to Y.

In the general formulae (M-1) and (M-2), T₁, T₂, and T₃ represent the general formula (1) and are identical to or different from one another. Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups. An unsubstituted alkyl group having 1 to 20 carbon atoms is preferable, and an n-butyl group is more preferable.

In the general formula (1), X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms. W represents the general formula (1A). "p" represents 1 or 2, and from the viewpoint of solvent solubility, preferably 1.

In the general formulae (M-1) and (M-2), T₁, T₂, and T₃ represent the general formula (1), and are identical to or different from one another. T₁, T₂, and T₃ may be a compound having a different crosslinking group (a hydroxy group or a structure represented by one of the general formulae (a-1) to (a-3)) in the molecule. When a different crosslinking group is present in the molecule, structures having both a hydroxy group and one of the structures represented by the general formulae (a-1) to (a-3) are preferable. Such structures make it possible to provide a compound for forming a metal-containing film having high levels of both adhesiveness to a substrate and thermal flowability.

Examples of preferable structures of the X in the general formula (1) include the following structures.

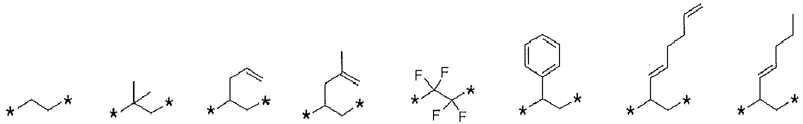

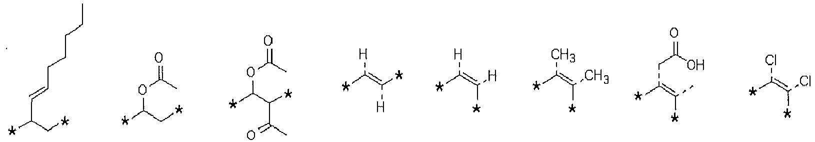

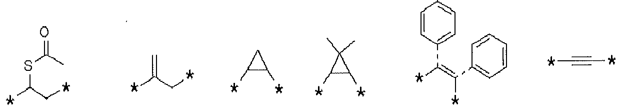

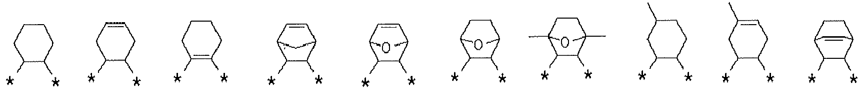

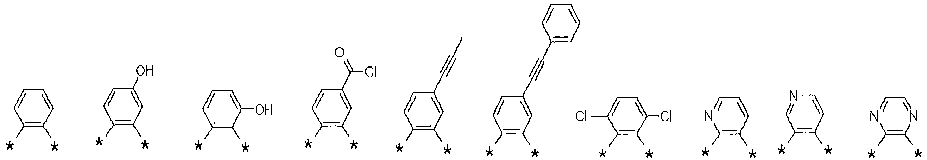

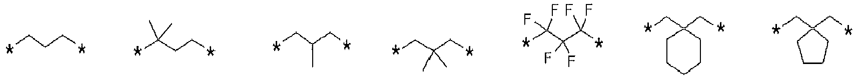

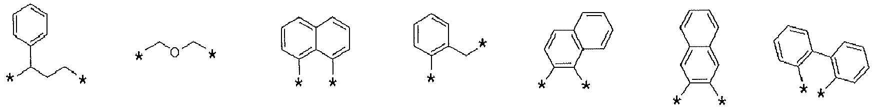

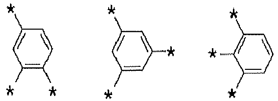

"*" represents an attachment point to the carbon atom of a carbonyl group.

In the general formula (1A), Y represents a saturated divalent organic group having 1 to 20 carbon atoms and optionally being substituted with a heteroatom or an unsaturated divalent organic group having 2 to 20 carbon atoms and optionally being substituted with a heteroatom. R^{A} represents a hydroxy group or a structure represented by one of the general formulae (a-1) to (a-3). "h" represents 1 to 6, preferably 1 to 2. Furthermore, a carbon atom of the organic groups may be substituted with a heteroatom such as an oxygen atom or a nitrogen atom.

In the general formulae (a-1) to (a-3), R₁ represents a hydrogen atom or a monovalent organic group having 1 to 10 carbon atoms and "q" represents 0 or 1. As further preferable structures, R₁ may represent a hydrogen atom, a methyl group, or a phenyl group optionally having a substituent, and from the viewpoints of thermal flowability and thermosetting property, a hydrogen atom is particularly preferable.

A compound for forming a metal-containing film having such a structure has at least two organic groups represented by the general formula (1), so that the compound for forming a metal-containing film has excellent solvent solubility and excellent heat resistance. Furthermore, the compound has a hydroxy group or a crosslinking group having a structure represented by one of the general formulae (a-1) to (a-3) at the end, so that rapid volume shrinkage during baking can be reduced, and since thermal flowability is also excellent, a resist underlayer film material having excellent filling and planarizing properties can be provided.

A metal-containing film formed by using an organotin compound generates radicals, while organic groups bonded to Sn atoms via C atoms are dissociated during baking. Radicals generated in this manner form - Sn-O-Sn- bonds and initiate a condensation polymerization reaction. Thus, curing of a metal-containing film progresses. Meanwhile, since organic groups are removed at the time of the reaction, great film shrinkage occurs during baking. However, since the above-described compound has at least two organic groups represented by the general formula (1) having a hydroxy group or a crosslinking group having a structure represented by one of the general formulae (a-1) to (a-3) at the compound terminal, so that pyrolysis can be alleviated, and since thermal flowability is excellent, a resist underlayer film material excellent in filling property can be provided.

In the general formula (1), the W preferably has a structure represented by the following general formula (1B).

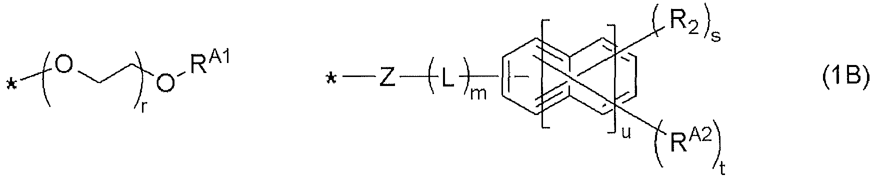

In the general formula (1B), R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "t" represents 1 to 6; "s" represents 0 to 5; t+s is 1 or more and 6 or less; "r" represents 1 to 10; "u" represents 0 or 1; "m" represents 0 or 1; and "*" represents an attachment point.

In the general formula (1B), R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "r" represents 1 to 10; "t" represents 1 to 6; "s" represents 0 to 5; t+s is 1 or more and 6 or less; "u" represents 0 or 1; and "m" represents 0 or 1. When "m" is 1, L is preferably methylene. As more preferable structures, "r" can be 1 to 4, "t" can be 1 to 2, "s" can be 0 to 1, and "m" can be 0. From the viewpoint of solvent solubility, "u" is preferably 1.

When W has the structure represented by the general formula (1B), the thermal flowability of the compound for forming a metal-containing film can be improved further.

In the general formula (1), X preferably represents an unsaturated hydrocarbon having 2 to 20 carbon atoms.

When the compound for forming a metal-containing film has such a structure, thermosetting property can be improved further.

The inventive compound for forming a metal-containing film preferably has a structure represented by the following general formula (2).

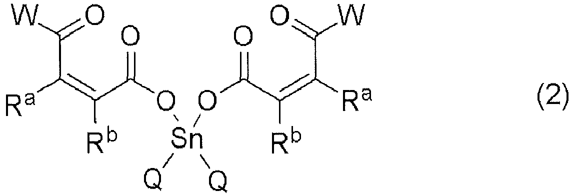

In the general formula (2), R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto. Q and W are as defined above.

In the general formula (2), R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto. Q and W are as described in the general formula (1). In view of the availability of raw materials, R^{a} and R^{b} represent a hydrogen atom in more preferable structures.

Depending on the structure represented by the general formula (2), geometrical isomers (cis isomer and trans isomer) regarding a double bond may exist in some cases, and in such a case, the isomers will be represented by a single formula. No inconvenience arises regarding the thermal flowability and thermosetting property of the inventive compound for forming a metal-containing film, either when one of the isomers is used or when the isomers are used in combination.

Specific examples of the organic groups bonded to the Sn of the compound represented by the general formula (2) include the following structures, but are not limited thereto.

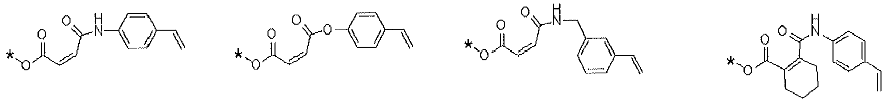

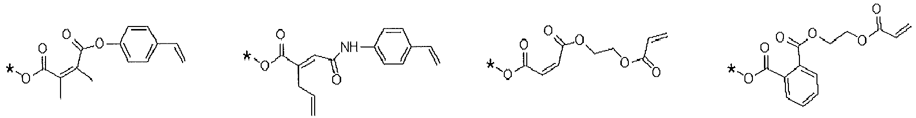

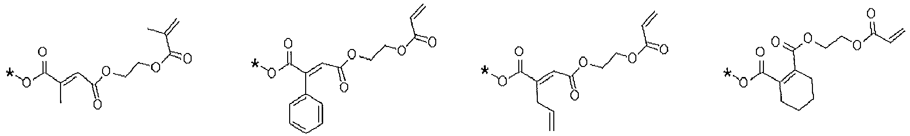

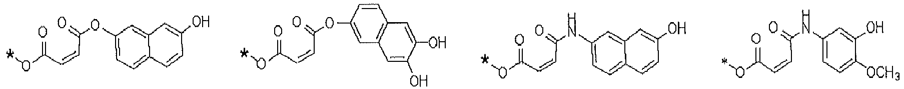

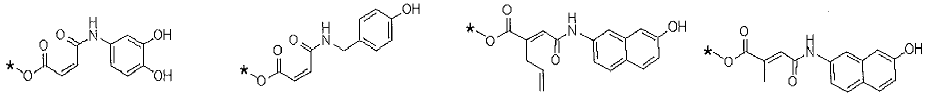

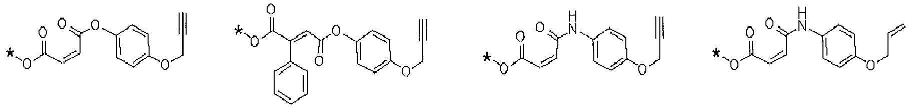

"*" represents an attachment point to the Sn.

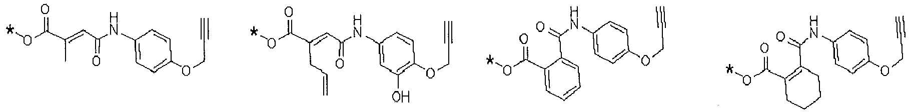

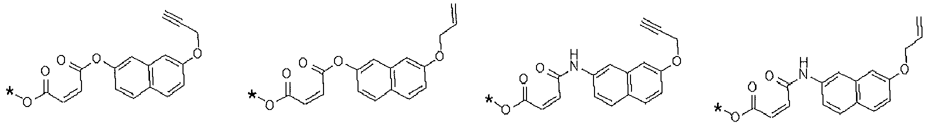

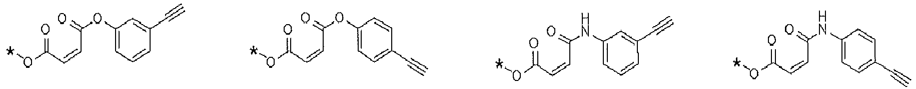

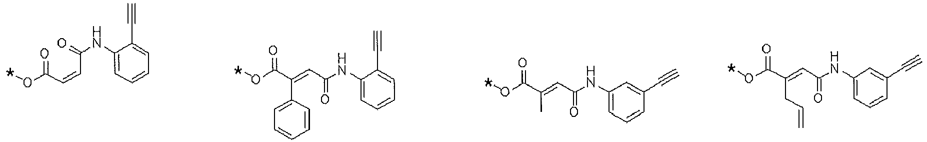

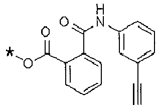

"*" represents an attachment point to the Sn.

The Mw/Mn (that is, the dispersity) of the compound for forming a metal-containing film is preferably within the range of 1.00 ≤ Mw/Mn ≤ 1.30, further preferably 1.00 ≤ Mw/Mn ≤ 1.10, where Mw is a weight-average molecular weight and Mn is a number-average molecular weight measured by gel permeation chromatography in terms of polystyrene. From the definition, Mw/Mn is 1.00 in the case of a monomolecular compound, but because of separation in GPC, the measured value exceeds 1.00 in some cases. Generally, it is extremely difficult to bring the Mw/Mn of a polymer having a repeating unit close to 1.00 unless a special polymerization method is used. Such a polymer has a distribution of Mw, and Mw/Mn exceeds 1. In the present invention, the range 1.00 ≤ Mw/Mn ≤ 1.30 is defined as an index to indicate monomerism in order to distinguish between monomolecular compounds and polymers.

A compound for forming a metal-containing film having dispersity within such a range has even better thermal flowability, so that when the compound is contained in a composition for forming a metal-containing film, not only is it possible to fill favorably fine structures formed on a substrate, it is also possible to form a resist underlayer film to planarize the entire substrate.

### <Composition for Forming Metal-Containing Film>

The present invention also provides a composition for forming a metal-containing film, the composition functioning as a resist underlayer film material and/or a resist material used in manufacturing a semiconductor, the composition containing: (A) the above-described compound for forming a metal-containing film; and (B) an organic solvent.

Such a composition for forming a metal-containing film contains an organotin compound having high levels of both thermal flowability and thermosetting property, and therefore, can provide a resist underlayer film material having better dry etching resistance than conventional resist underlayer film materials and also having high filling and planarizing properties.

Moreover, the composition is excellent in curability, so that when the composition is contained in a resist material, it is possible to provide a metal-containing resist material having high sensitivity and high resolution in EUV and electron beam lithography.

In the following, the components contained in the inventive composition for forming a metal-containing film other than the compound (A) for forming a metal-containing film will be described.

### <(B) Organic Solvent>

The organic solvent (B) usable in the inventive composition for forming a metal-containing film is not particularly limited as long as the solvent can dissolve or disperse the compound (A) for forming a metal-containing film and, when contained, (C) a crosslinking agent, (D) a high-boiling-point solvent, (E) a surfactant, (F) a flowability accelerator, (G) metal oxide nanoparticles having an average primary particle size of 100 nm or less, (H) a photo-acid generator, other additives, etc. described below.

Specifically, an organic solvent disclosed in paragraphs [0091] and [0092] in JP2007-199653A may be contained. Furthermore, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the compound (A) for forming a metal-containing film.

### <Composition for Forming Resist Underlayer Film>

When the composition for forming a metal-containing film is usable as a resist underlayer film used in a multilayer resist method, at least one kind of the compound (A) for forming a metal-containing film and the organic solvent (B) is contained, and as necessary, the composition may contain additives such as a crosslinking agent (C), a high-boiling-point solvent (D), a surfactant (E), a flowability accelerator (F), and metal oxide nanoparticles (G) having an average primary particle size of 100 nm or less. In the present description, a composition for forming a metal-containing film usable as a resist underlayer film used in a multilayer resist method is also referred to as a composition for forming a resist underlayer film.

In the following, the components contained in the composition of the present invention for forming a resist underlayer film other than the compound (A) for forming a metal-containing film and the organic solvent (B) will be described.

### <(D) High-Boiling-Point Solvent>

In the composition of the present invention for forming a resist underlayer film, the organic solvent (B) may be a mixture of one or more kinds of organic solvent having a boiling point of lower than 180°C and one or more kinds of organic solvent having a boiling point of 180°C or higher ((D) a high-boiling-point solvent).

The high-boiling-point solvent (D) is not particularly limited to hydrocarbons, alcohols, ketones, esters, ethers, or chlorine-based solvents as long as the solvent is capable of dissolving or dispersing the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (D) may be selected suitably from the solvents above, for example, depending on the temperature at which the composition of the present invention for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (D) is used, the contained amount is preferably 1 to 30 parts by mass per 100 parts by mass of the organic solvent (B), having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### [(C) Crosslinking Agent]

To increase the curability of the compound for forming a metal-containing film and further inhibit intermixing with the resist upper layer film, the composition of the present invention for forming a resist underlayer film may also contain a crosslinking agent (C). The crosslinking agent (C) is not particularly limited, and various known crosslinking agents can be widely used. Examples include melamine-based crosslinking agents, acrylate-based crosslinking agents, glycoluril-based crosslinking agents benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The crosslinking agent (C) is preferably contained in an amount of 5 to 50 parts by mass, more preferably 10 to 40 parts by mass relative to 100 parts by mass of the compound for forming a metal-containing film (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

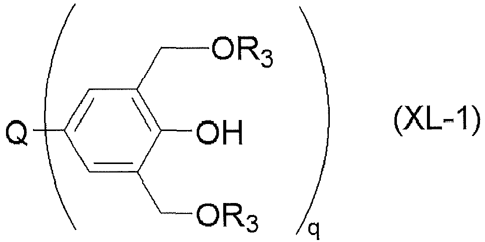

In the formula, Q represents a single bond or q-valent hydrocarbon group having 1 to 20 carbon atoms. R₃ represents a hydrogen atom or an alkyl group having 1 to 20 carbon atoms. "q" represents an integer of 1 to 5. The symbols are applied only to this formula.

Q represents a single bond or a hydrocarbon group having a valency of "q" and having 1 to 20 carbon atoms. "q" represents an integer of 1 to 5, preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, triphenolmethane, triphenolethane, 1,1,1,-tris(4-hydroxyphenyl)ethane, and a hexamethoxymethylated derivative of tris(4-hydroxyphenyl)-1-ethyl-4-isopropylbenzene are preferable from the viewpoint of improving the curability and film thickness uniformity of the organic film. R₃ is as defined above.

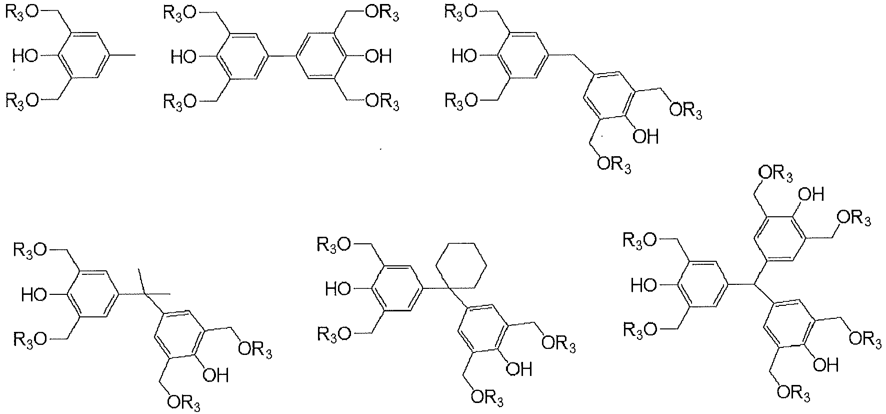

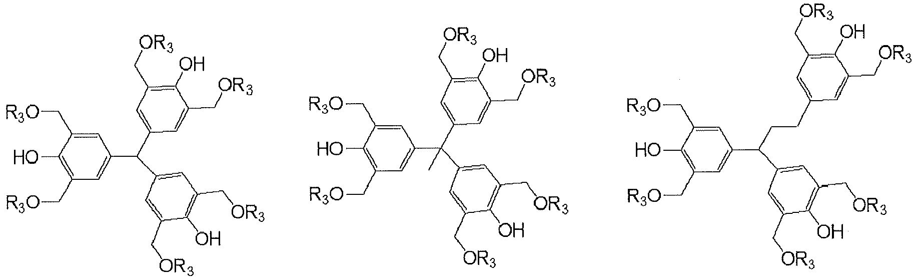

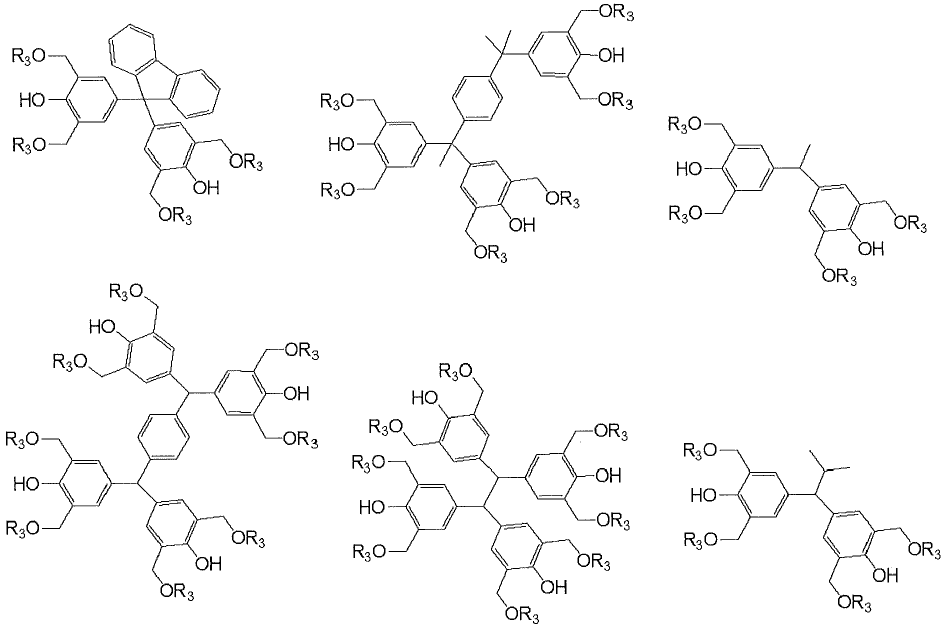

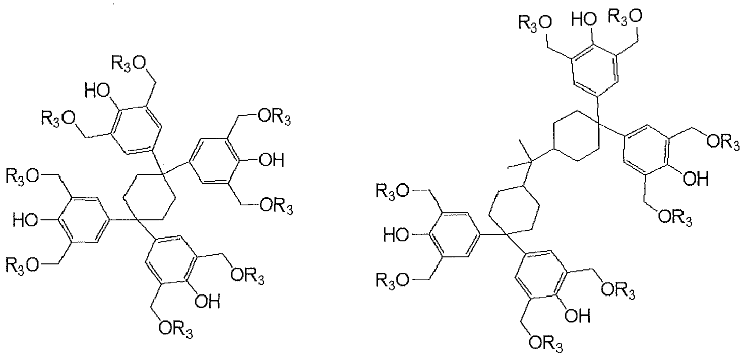

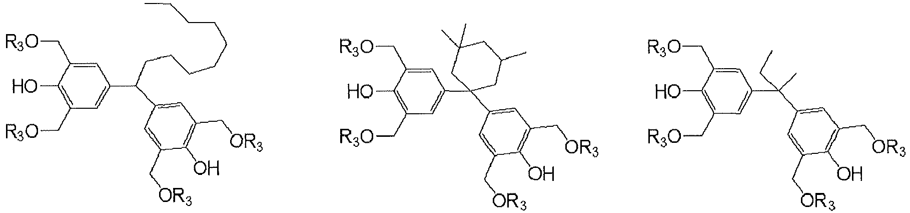

### <(E) Surfactant>

A surfactant (E) may be contained in the composition for forming a resist underlayer film of the present invention in order to improve coating property in spin-coating. Examples of the surfactant include those disclosed in paragraphs [0142] to [0147] of JP2009-269953A. When the surfactant is contained, the contained amount is preferably 0.01 to 10 parts by mass, more preferably 0.05 to 5 parts by mass per 100 parts by mass of the compound (A) for forming a metal-containing film.

### <(F) Flowability Accelerator>

Another compound or polymer may be further blended in the composition for forming a resist underlayer film of the present invention. The flowability accelerator (F) is mixed with the inventive compound for forming a metal-containing film and serves to improve the film-formability by spin-coating and the filling property for a stepped substrate. Furthermore, as the flowability accelerator (F), a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2' ,3'-tetrahydro-(1,1')-spirobiindene-6,6'-diol, 3,3,3' ,3' ,4,4'-hexamethyl-2,3,2' ,3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalene such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, an adamantane phenol compound and a novolak resin thereof disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, and the like. The flowability accelerator (F) is preferably contained in an amount of 0.001 to 100 parts by mass, more preferably 0.01 to 50 parts by mass based on 100 parts by mass of the inventive compound (A) for forming a metal-containing film.

In addition, in the composition for forming a resist underlayer film of the present invention, it is preferable to use, as an additive for imparting filling and planarizing properties, for example, a liquid additive having a polyethylene glycol or polypropylene glycol structure, or a thermo-decomposable polymer having a weight reduction rate of 40% by mass or more at 30°C to 250°C and a weight-average molecular weight of 300 to 200,000. This thermo-decomposable polymer preferably contains a repeating unit having an acetal structure represented by the following general formula (DP1) or (DP1a).

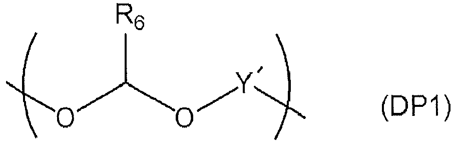

In the formula, R₆ represents a hydrogen atom or a substituted or unsubstituted, saturated or unsaturated monovalent organic group having 1 to 30 carbon atoms. Y' represents a saturated or unsaturated divalent organic group having 2 to 30 carbon atoms.

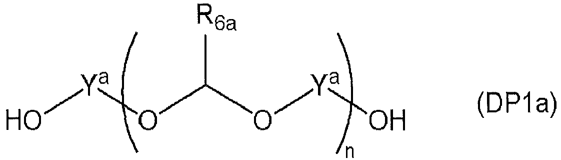

In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <(G) Metal Oxide Nanoparticles>

The composition for forming a resist underlayer film of the present invention can also contain metal oxide nanoparticles (G) in order to improve dry etching resistance further. Specifically, metal oxide nanoparticles selected from the group consisting of zirconium oxide nanoparticles, hafnium oxide nanoparticles, titanium oxide nanoparticles, tin oxide nanoparticles, and tungsten oxide nanoparticles are preferable.

By selecting such metal oxide nanoparticles, it is possible to form a metal-containing film having better dry etching resistance.

The metal oxide nanoparticles (G) preferably has an average primary particle size of 100 nm or less, more preferably an average primary particle size of 50 nm or less, further preferably an average primary particle size of 30 nm or less, and particularly preferably 15 nm or less. The average primary particle size of the metal oxide nanoparticles before being dispersed in an organic solvent can be determined by a method of measuring the size of primary particles directly from an electron microscope photograph. Specifically, the minor axis diameter and the major axis diameter of each primary particle are measured, and the average of the values is defined as the particle size of the particle. Then, for 100 or more particles, the volume (mass) of each particle is approximated to a cuboid of the determined particle size, and this volume average particle size is determined as the average particle size. Identical results can be obtained when any of a transmission type electron microscope (TEM), a scanning type electron microscope (SEM), and a scanning transmission type electron microscope (STEM) are used.

When the particle size is within such ranges, the particles can exhibit excellent dispersity in a composition for forming a resist underlayer film, and can enhance the dry etching resistance of a metal-containing film without causing the degradation of filling and planarizing properties in dense portions of a fine pattern structure.

### <Acid Generator>

An acid generator may be contained in the composition for forming a resist underlayer film of the present invention in order to promote the curing reaction of the compound (A) for forming a metal-containing film further. The acid generator can be classified into those that generate an acid by thermal decomposition and those that generate an acid by optical irradiation; however, any acid generator can be added. Specific examples of the acid generator include, but are not limited to, the materials disclosed in paragraphs [0061] to [0085] of JP2007-199653A.

One kind of the acid generator can be used, or two or more kinds can be used in combination. When an acid generator is contained, the contained amount is preferably 0.05 to 50 parts by mass, more preferably 0.1 to 10 parts by mass relative to 100 parts by mass of the compound (A) for forming a metal-containing film.

### <Semiconductor Photoresist Material>

The present invention can also provide a semiconductor photoresist material containing a composition for forming a metal-containing film containing the compound (A) for forming a metal-containing film and an organic solvent (B).

When the composition is a composition for forming a metal-containing film usable as a resist material, one or more kinds of the compound (A) for forming a metal-containing film and an organic solvent (B) are contained, and as necessary, the composition can also contain an additive, such as a photo-acid generator (H), a surfactant, and a quencher.

In the following, the components contained in the inventive semiconductor photoresist material other than the compound (A) for forming a metal-containing film and the organic solvent (B) will be described.

As the photo-acid generator (H), the material may contain, for example, a compound (photo-acid generator) that generates an acid in response to actinic light or radiation. The photo-acid generator can be any compound as long as the compound generates an acid upon irradiation with a high-energy beam. Suitable examples of the photo-acid generator include sulfonium salts, iodonium salts, sulfonyldiazomethane, N-sulfonyloxyimide, and oxime-O-sulfonate acid generators. Specific examples of acid generators include those disclosed in paragraphs [0122] to [0142] of JP2008-111103A, JP2009-080474A, JP2015-026064A, and paragraphs [0056] to [0068] of JP2021-039171A. One of these acid generators may be used or two or more thereof may be used in combination. When an acid generator is contained, the contained amount is preferably 0.1 to 50 parts by mass relative to 100 parts by mass of the compound (A) for forming a metal-containing film.

As the quencher, the material may contain, for example, a compound having a basicity for neutralizing the acid generated from the photo-acid generator (H). Containing a quencher makes it possible to adjust sensitivity, and is also effective for preventing a resist film in unexposed regions and low-exposure regions from becoming insoluble and for suppressing the generation of residue. Examples of suitable quenchers include nitrogen-containing compounds such as primary, secondary, and tertiary aliphatic amines, mixed amines, aromatic amines, heterocyclic amines, nitrogen-containing compounds having a carboxy group(s), nitrogen-containing compounds having a sulfonyl group(s), nitrogen-containing compounds having a hydroxy group(s), nitrogen-containing compounds having a hydroxyphenyl group(s), alcoholic nitrogen-containing compounds, amides, imides, and carbamates. Specific examples of the quenchers include those disclosed in paragraphs [0072] to [0086] of JP2021-039171A. One of these quenchers may be used, or two or more thereof may be used in combination. When a quencher is contained, the contained amount is preferably 0.001 to 5 parts by mass, particularly preferably 0.01 to 3 parts by mass based on 100 parts by mass of the compound (A) for forming a metal-containing film. When the contained amount is 0.001 parts by mass or more, sufficient blending effect can be achieved, and when the amount is 5 parts by mass or less, there is no risk of sensitivity being degraded.

Furthermore, the resist material of the present invention can also contain a surfactant as necessary. Specifically, a surfactant similar to the surfactant in the composition for forming a resist underlayer film can be used as such a surfactant. When a surfactant is contained, the contained amount is preferably 0.01 to 5 parts by mass based on 100 parts by mass of the compound (A) for forming a metal-containing film.

### <Method for Forming Resist Underlayer Film>

In the present invention, it is possible to form, by using the above-described composition for forming a metal-containing film, a resist underlayer film of a multilayer resist film used in lithography or a filling film that serves as a planarizing film for the manufacture of semiconductor.

In the method for forming a resist underlayer film by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing of the resist upper layer film and the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

### <Patterning Process Using Composition for Forming Metal-Containing Film>

The present invention provides, as a patterning process according to a two-layer resist process using the above-described composition for forming a metal-containing film, the patterning process including:
forming a metal-containing film on a substrate to be processed by using the composition for forming a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask; and
processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

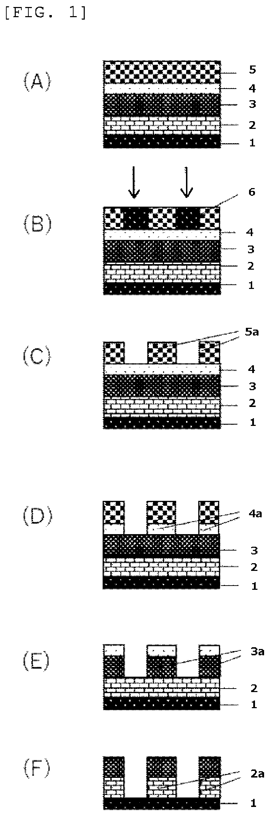

With reference to FIG. 1, a patterning process according to a three-layer resist process will be described. The present invention provides, as a patterning process according to a three-layer resist process using such a composition for forming a metal-containing film, the patterning process including:
forming a metal-containing film 3 on a layer 2 to be processed on a substrate 1 to be processed by using the composition for forming a metal-containing film, forming a resist middle layer film 4 on the metal-containing film by using a resist middle layer film material, and forming a resist upper layer film 5 on the resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a resist middle layer film pattern 4a to the resist middle layer film by dry etching while using the resist upper layer film having the formed pattern as a mask as in FIG. 1(D);
transferring a metal-containing film pattern 3a to the metal-containing film by dry etching while using the resist middle layer film having the transferred pattern as a mask as in FIG. 1(E); and
processing the layer to be processed on the substrate to be processed while using the metal-containing film having the formed pattern as a mask to form a pattern 2a on the substrate to be processed 1 as in FIG. 1(F).

Examples of the resist middle layer film in the three-layer resist process include a silicon-containing resist middle layer film. The silicon-containing resist middle layer film exhibits etching resistance with respect to a chlorine-based gas and a hydrogen-based gas. Therefore, the dry etching of the metal-containing film that is performed while using the silicon-containing resist middle layer film as a mask in the three-layer resist process is preferably performed using an etching gas mainly containing a chlorine-based gas or a hydrogen-based gas.

As the silicon-containing resist middle layer film in the three-layer resist process, a polysiloxane-based middle layer film is also preferably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a composition for forming a metal-containing film, the patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern can be formed on a substrate, at least, by:
forming a metal-containing film on a body to be processed by using the inventive composition for forming a metal-containing film;
forming an inorganic hard mask middle layer film selected from a silicon oxide film, a silicon nitride film, and a silicon oxynitride film on the metal-containing film;
forming a resist upper layer film on the inorganic hard mask middle layer film by using a photoresist composition;
forming a circuit pattern in the resist upper layer film;
etching the inorganic hard mask middle layer film while using the resist upper layer film having the formed pattern as a mask;
etching the metal-containing film while using the inorganic hard mask middle layer film having the formed pattern as a mask; and
furthermore, etching the body to be processed while using the metal-containing film having the formed pattern as a mask to form the pattern in the body to be processed.

As described above, when the inorganic hard mask middle layer film is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most preferably used as the inorganic hard mask. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In addition, the present invention provides a patterning process according to a multilayer resist process using such a composition for forming a metal-containing film. In this case, a semiconductor device circuit pattern can be formed on a substrate in the following manner:
forming a resist underlayer film on a substrate to be processed;
applying the inventive composition for forming a metal-containing film onto the resist underlayer film and then heating to form a metal-containing film;
forming a resist upper layer film on the metal-containing film by using a photoresist material;
subjecting the resist upper layer film to pattern exposure and then development with a developer to form a pattern in the resist upper layer film;
transferring the pattern to the metal-containing film by dry etching while using the resist upper layer film having the formed pattern as a mask;
transferring the pattern to the resist underlayer film by dry etching while using the metal-containing film having the transferred pattern as a mask; and
furthermore, processing the substrate to be processed while using the resist underlayer film having the formed pattern as a mask to form the pattern in the substrate to be processed.

A photoresist film may be formed on the metal-containing film as a resist upper layer film as described above. Alternatively, an organic adhesive film may be formed on the metal-containing film by spin-coating, and a photoresist film may be formed thereon.

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist upper layer film in the multilayer resist process described above may be either a positive type or a negative type, and it is possible to use a film similar to the typically used photoresist composition. The prebaking, which is conducted after the spin-coating with the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Furthermore, examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask middle layer film in the three-layer resist process is performed while using the upper layer resist pattern as a mask by using a fluorocarbon-based gas. In this manner, a silicon-containing resist middle layer film pattern or an inorganic hard mask middle layer film pattern is formed.

Next, the metal-containing film is etched while using the obtained silicon-containing resist middle layer film pattern or inorganic hard mask middle layer film pattern as a mask. The etching of the metal-containing film is preferably performed using an etching gas mainly containing a chlorine-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiOz, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat cured film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very preferable.

### <Tone-Reversal Patterning Process Using Composition for Forming Metal-Containing Film>

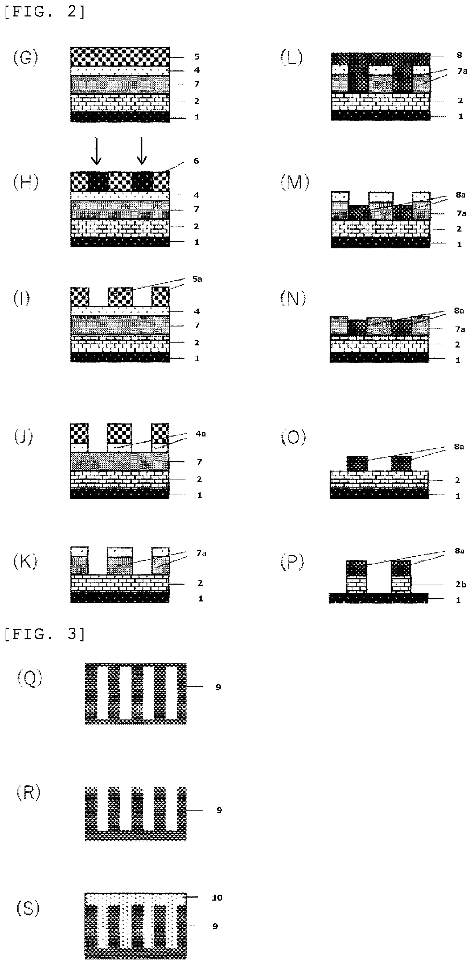

With reference to FIG. 2, a tone-reversal patterning process using a composition for forming a metal-containing film will be described. The present invention provides, as a tone-reversal patterning process using such a composition for forming a metal-containing film, a tone-reversal patterning process including the steps of:
forming a resist underlayer film 7 on a layer 2 to be processed on a substrate 1 to be processed, forming a resist middle layer film 4 or a combination of an inorganic hard mask middle layer film selected from a silicon oxide film, a silicon nitride film, and a silicon oxynitride film and an organic thin film on the resist underlayer film 7, and forming a resist upper layer film 5 on the resist middle layer film 4 or the combination of the inorganic hard mask middle layer film and the organic thin film by using a photoresist material as in FIG. 2(G);
subsequently subjecting an exposure portion 6 of the resist upper layer film to pattern exposure as in FIG. 2(H) and then development with a developer to form a resist upper layer film pattern 5a in the resist upper layer film as in FIG. 2(I);
transferring a resist middle layer film pattern 4a or an inorganic hard mask middle layer film pattern to the resist middle layer film or the organic thin film and the inorganic hard mask middle layer film by dry etching while using the resist upper layer film having the formed pattern as a mask as in FIG. 2(J);
transferring a resist underlayer film pattern 7a to the resist underlayer film by dry etching while using the resist middle layer film or the inorganic hard mask middle layer film having the transferred pattern as a mask as in FIG. 2(K);
covering the resist underlayer film having the formed pattern with a metal-containing film 8 by using the above-described composition for forming a metal-containing film, thereby filling a space between the resist underlayer film patterns 7a with the metal-containing film 8 as in FIG. 2(L);
etching back the metal-containing film covering the resist underlayer film having the formed pattern by a chemical stripper or dry etching to form a reversed metal-containing film pattern 8a to expose an upper surface of the resist underlayer film having the formed pattern as in FIG. 2(M);
removing the resist middle layer film or the inorganic hard mask middle layer film remaining on the upper surface of the resist underlayer film pattern 7a by dry etching as in FIG. 2(N);
removing the resist underlayer film having the formed pattern with its surface exposed by dry etching to form a reverse pattern of the original pattern in the metal-containing film as in FIG. 2(O); and
processing the layer to be processed while using the metal-containing film having the formed reverse pattern as a mask to form the reverse pattern 2b in the layer to be processed as in FIG. 2(P).

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat cured film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very preferable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type organic underlayer film material.

### <Patterning Process Using Photoresist Material>

As a patterning process using the above-described resist material, the present invention provides a patterning process including the steps of:
(s1) applying the above-described resist material onto a substrate;
(s2) performing a heat treatment;
(s3) performing exposure with a high-energy beam; and
(s4) performing development by using a developer.

Incidentally, a heat treatment step may also be applied after the exposure in addition to the treatment after the application. A heat treatment after exposure to light is effective for achieving higher sensitivity and higher contrast.

In the step (s1), the method for applying the resist material onto the substrate is not particularly limited, and the application can be performed by an existing method. For example, the resist material can be applied onto a substrate for producing an integrated circuit or a layer to be processed (Si, SiO₂, SiN, SiON, TiN, WSi, BPSG, SOG, organic antireflective film, etc.) on the substrate, or onto a substrate for producing a mask circuit or a layer to be processed (Cr, CrO, CrON, MoSi₂, SiO₂, etc.) on the substrate by an appropriate application method, such as spin coating, roll coating, flow coating, dip coating, spray coating, doctor coating, etc. so that the coating film thickness is 0.01 to 2.0 µm.

In the step (s2), the method for performing the heat treatment is not particularly limited, and for example, the heat treatment can be performed on a hot plate at 60 to 400°C for 10 seconds to 30 minutes, preferably at 100 to 350°C for 30 seconds to 20 minutes by prebaking.

In the step (s3) of exposing the resist film to a high-energy beam, it is preferable to use, as the high-energy beam, an extreme ultraviolet ray having a wavelength of 3 to 15 nm or an electron beam having an acceleration voltage of 1 to 250 kV from the viewpoints of sensitivity and resolution. Radicals are generated by irradiation with a high-energy beam, while organic groups bonded to Sn atoms via C atoms are dissociated during baking. Radicals generated in this manner form - Sn-O-Sn- bonds and initiate a condensation polymerization reaction. Thus, curing of a metal-containing film progresses. It is considered that solubility in a developer changes in this manner.

In the development step (s4), the developer is not particularly limited, and a suitable developer can be selected depending on the resist material used. However, an organic solvent is preferable. Specifically, the developer preferably contains one or more organic solvents selected from 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate. The total concentration of these organic solvents is preferably 60 mass% or more of the total amount of the developer.

When a developer containing such an organic solvent is used, a negative pattern, where unexposed portions dissolve and exposed portions remain as patterns, can be formed.

### EXAMPLE

The present invention is more specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### [Synthesis Examples]

In the following Synthesis Examples and Comparative Synthesis Examples, the following starting material group G: (G1) to (G14) was used.

The starting material group G: (G1) to (G14) is shown below.

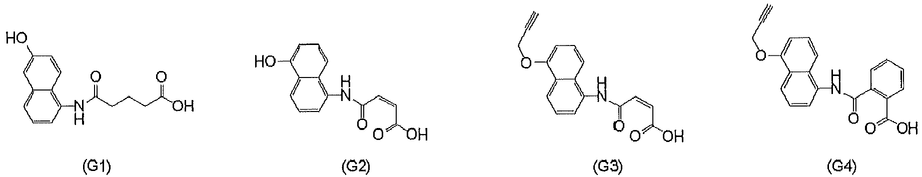

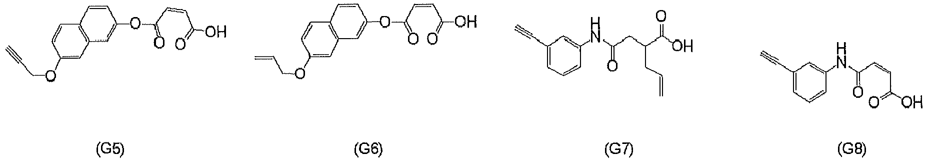

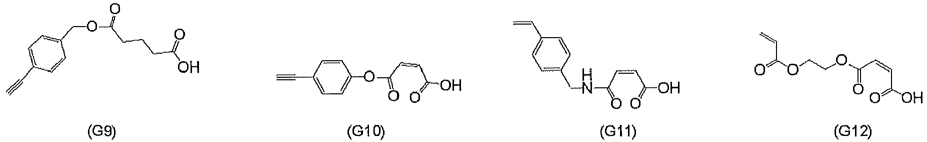

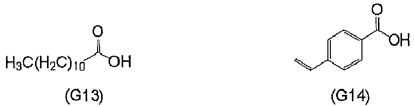

### [Synthesis Example 1] Synthesis of Compound for Forming Metal-Containing Film (A-1)

5.0 g of dibutyltin oxide, 11.0 g of the carboxylic acid (G1), and 100 g of toluene were added together, and refluxed for 7 hours while removing water. After the reaction, the solvent was removed under reduced pressure. Hexane was added to the resulting solution, and filtration and washing were performed. The collected solid was dried under vacuum at 70°C to give a compound (A-1).
(A-1): Mw = 254, Mw/Mn = 1.18

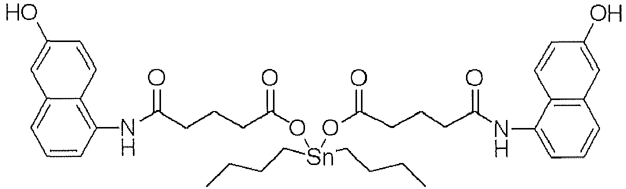

### [Synthesis Examples 2 to 12 and Comparative Synthesis Examples 1 and 2] Synthesis of Compounds (A-2) to (A-12) and Compounds (R-1) and (R-2) for Comparative Examples

The compounds (A-2) to (A-12) and the compounds (R-1) and (R-2) for the Comparative Examples shown in Tables 1 to 3 were obtained under the same reaction conditions as in Synthesis Example 1, except that the compound group G and dibutyltin oxide were used at the charging amounts shown in Tables 1 to 3. Since (A-10), (R-1), and (R-2) are liquid, only the removal of toluene was performed. The weight-average molecular weight (Mw) and the dispersity (Mw/Mn) of these compounds were determined. Table 4 shows the results.

**[Table 1]**

| Synthesis Example | Dibutyltin oxide | Compound group G | Compound |
|---|---|---|---|
| 1 | 5.0 g | G1 (11.0 g) | 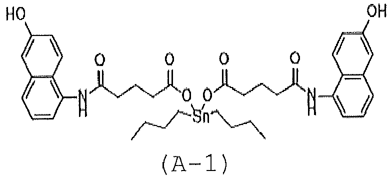 |
| 2 | 5.0 g | G2 (10.3 g) | 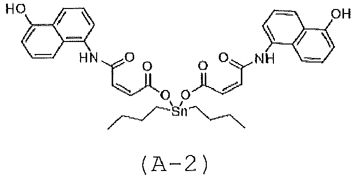 |
| 3 | 5.0 g | G3 (11.9 g) | 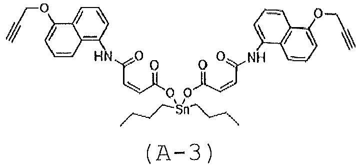 |
| 4 | 5.0 g | G4 (13.9 g) | 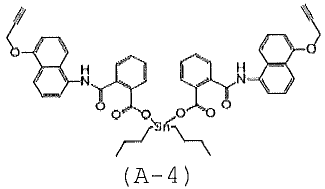 |
| 5 | 5.0 g | G5 (11.9 g) | 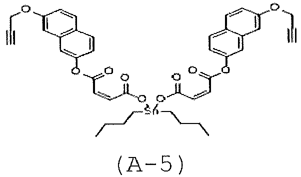 |
| 6 | 5.0 g | G6 (12.0 g) | 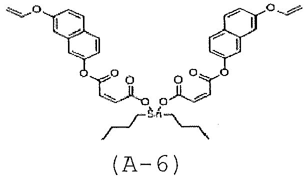 |

**[Table 2]**

| Synthesis Example | Dibutyltin oxide | Compound group G | Compound |
|---|---|---|---|
| 7 | 5.0 g | G7 (10.3 g) | 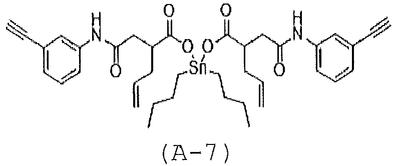 |
| 8 | 5.0 g | G8 (8.6 g) | 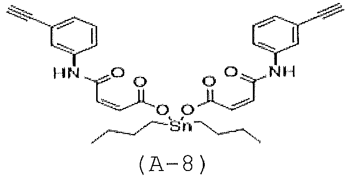 |
| 9 | 5.0 g | G9 (9.9 g) | 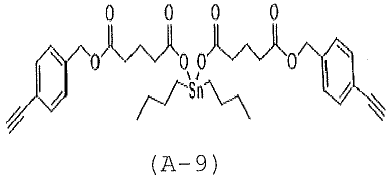 |
| 10 | 5.0 g | G10 (8.7 g) | 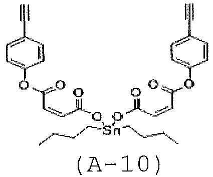 |
| 11 | 5.0 g | G11 (9.3 g) | 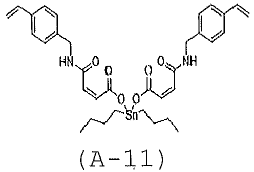 |
| 12 | 5.0 g | G12 (8.6 g) | 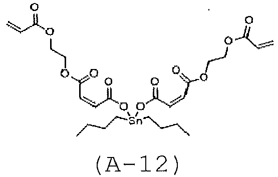 |

**[Table 3]**

| Comparative Synthesis Example | Dibutyltin oxide | Compound group G | Compound for Comparative Example |
|---|---|---|---|
| 1 | 5.0 g | G13 (8.0 g) | 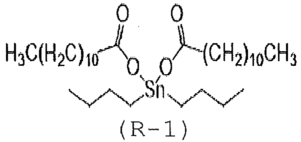 |
| 2 | 5.0 g | G14 (6.0 g) | 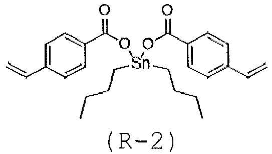 |

**[Table 4]**

| Compound | Mw | Mw/Mn |
|---|---|---|
| A-1 | 254 | 1.18 |
| A-2 | 251 | 1.01 |
| A-3 | 267 | 1. 03 |
| A-4 | 335 | 1.07 |
| A-5 | 261 | 1.02 |
| A-6 | 260 | 1.02 |
| A-7 | 342 | 1.07 |
| A-8 | 152 | 1.02 |
| A-9 | 313 | 1.24 |
| A-10 | 158 | 1.04 |
| A-11 | 253 | 1.10 |
| A-12 | 385 | 1.02 |
| R-1 | 336 | 1.03 |
| R-2 | 91 | 1.10 |

### [Synthesis of Compound (R-3) for Forming Metal-Containing Film for Comparative Example]

8.0 g of butyltin trichloride was stirred at room temperature, and 10 g of acrylic acid was dropped thereto. After that, the temperature was raised to 80°C, and the mixture was stirred for 7 hours. After the completion of the reaction, the acrylic acid was removed under reduced pressure, and (R-3) was obtained. (R-3): Mw = 51, Mw/Mn = 1.14

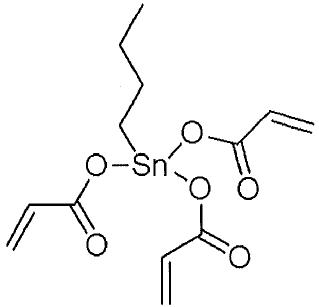

### [Synthesis of Compound (R-4) for Forming Metal-Containing Film for Comparative Example]

As a compound having a different metal from the inventive compound for forming a metal-containing film, a titanium compound reported in [Synthesis Example A-II] of JP6189758B2 was synthesized.

An IPA solution (500 g) of deionized water (27 g) was agitated with an IPA solution (500 g) of a titanium tetraisopropoxide (manufactured by Tokyo Chemical Industry Co., Ltd.) (284 g) and dropped at room temperature for 2 hours. 2-methyl-2,4-pentanediol (120 g) was added to a solution obtained and agitated at room temperature for 30 minutes. After the solution was concentrated under reduced pressure at 30°C, it was heated to 60°C and heating was continued under reduced pressure to generate no distillate. Then, PGMEA (1,200 g) was added thereto and heated under reduced pressure at 40°C until no IPA was distilled to obtain a PGMEA solution of a titanium-containing compound (R-4) (1,000 g) (compound concentration: 20 mass%). The molecular weight of the compound measured in terms of polystyrene was Mw = 1,100.

### [Synthesis of Resin (R-5) for Forming Organic Film for Comparative Example]

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-5).

The weight-average molecular weight (Mw) and the dispersity (Mw/Mn) were determined by GPC, and the following results were obtained.
(R-5): Mw = 3,300, Mw/Mn = 2.54

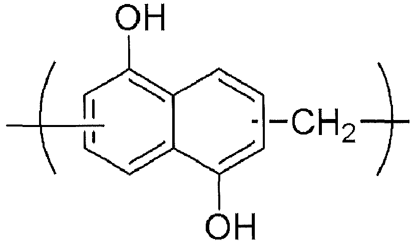

### [Composition for Forming Metal-Containing Film UDL-1]

The compound (A-1) for forming a metal-containing film was dissolved at a ratio shown in Table 5 in a mixed solvent of propylene glycol monomethyl ether acetate (PGMEA) and cyclohexanone (CyHO) containing 0.5 mass% of a surfactant FC-4430 (manufactured by Sumitomo 3M Limited), and the solution was filtered through a 0.02-µm membrane filter to prepare a composition (UDL-1) for forming a metal-containing film.

### [Preparation of Compositions (UDL-2 to -15) for Forming Metal-Containing Film and Compositions (Comparative UDL-1 to -5) for Forming Metal-Containing Film for Comparative Examples]

Each chemical liquid was prepared in the same manner as UDL-1, except that the type and the contained amount of each component were as shown in Table 5. In Table 5, "-" indicates that the component was not used. The following formulae (C-1) and (C-2) were used for the crosslinking agent, the following formula (F-1) was used for the acid generator (TAG), 1,6-diacetoxyhexane (boiling point: 260°C) was used as the high-boiling-point solvent (D-1), and a polymer (BP-1) for a flowability accelerator was used as the flowability accelerator.

### [Crosslinking Agent]

The crosslinking agent (C-1) used in a composition for forming a metal-containing film is shown below. Dipentaerythritol Hexaacrylate (manufactured by Tokyo Chemical Industry Co., Ltd.) was used as the crosslinking agent (C-2).

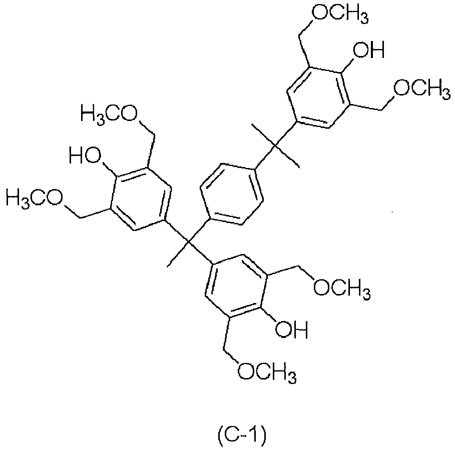

### [Thermal Acid Generator]

The thermal acid generator (F-1) used in a composition for forming a metal-containing film is shown below.

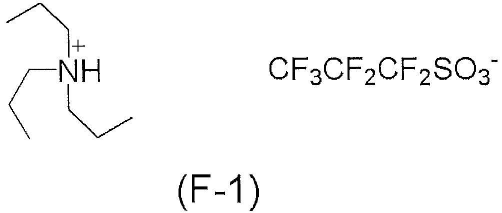

### [Synthesis Example of Polymer for Flowability Accelerator] Synthesis of Polymer (BP-1) for Flowability Accelerator

Under a nitrogen atmosphere, 20.0 g of cresol novolak, 27.6 g of potassium carbonate, and 100 g of DMF were added, and a homogeneous dispersion was prepared at an internal temperature of 50°C. 11.9 g of propargyl bromide was added slowly, followed by a reaction at an internal temperature of 50°C for 24 hours. 300 ml of methylisobutylketone and 300 g of pure water were added to a reaction solution to dissolve the precipitated salts. Thereafter, the separated water layer was removed. Further, the organic layer was washed with 100 g of a 3% aqueous nitric acid solution and 100 g of pure water six times, and then the organic layer was dried under reduced pressure to hardness, thereby obtaining a resin (BP-1).

The weight-average molecular weight (Mw) and the dispersity (Mw/Mn) were determined by GPC, and the following results were obtained.
(BP-1): Mw = 8,500, Mw/Mn = 3.46

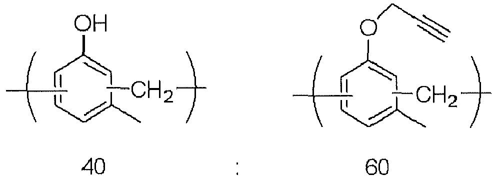

**[Table 5]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (15) | - | PGMEA/CyHO (50/35) |
| UDL-2 | A-2 (15) | - | PGMEA/CyHO (50/35) |
| UDL-3 | A-3 (15) | - | PGMEA/CyHO (50/35) |
| UDL-4 | A-4 (15) | - | PGMEA/CyHO (50/35) |
| UDL-5 | A-5 (15) | - | PGMEA (85) |
| UDL-6 | A-6 (15) | - | PGMEA (85) |
| UDL-7 | A-7 (15) | C-1 (3) | PGMEA (85) |
| UDL-8 | A-8 (15) | - | PGMEA (85) |
| UDL-9 | A-9 (15) | - | PGMEA (85) |
| UDL-10 | A-10 (15) | - | PGMEA (85) |
| UDL-11 | A-11 (15) | - | PGMEA (85) |
| UDL-12 | A-12 (15) | - | PGMEA (85) |
| UDL-13 | A-8 (10) | BP-1 (2) | PGMEA (88) |
| UDL-14 | A-8 (15) | D-1 (5) | PGMEA (80) |
| UDL-15 | A-12 (15) | C-2 (2) F-1 (0.1) | PGMEA (83) |
| Comparative UDL-1 | R-1 (10) | - | PGMEA (90) |
| Comparative UDL-2 | R-2 (15) | - | PGMEA/CyHO (50/35) |
| Comparative UDL-3 | R-3 (15) | - | PGMEA (85) |
| Comparative UDL-4 | R-4 (10) | - | PGMEA (90) |
| Comparative UDL-5 | R-5 (5) | - | PGMEA (95) |

### [Heat Resistance Evaluation and Solvent Resistance Evaluation (Examples 1-1 to 1-15 and Comparative Examples 1-1 to 1-5)]

Each of the compositions (UDL-1 to -15 and comparative UDL-1 to -5) for forming a metal-containing film prepared as described above was respectively applied onto a silicon substrate and baked at 100°C for 60 seconds, and then the film thickness (a [nm]) was measured. Subsequently, after baking at the baking temperature shown in Table 6 for 60 seconds, the film thickness (b [nm]) was measured, and the difference between the film thicknesses (film remaining percentage: (b/a) × 100) before and after the additional baking was determined.

Furthermore, a PGMEA solvent was dispensed thereon, left to stand for 30 seconds, spin-dried, and baked at 100°C for 60 seconds to evaporate the PGMEA. The film thickness (c [nm]) was then measured. The difference between the film thicknesses (film remaining percentage: (c/b) × 100) before and after the PGMEA treatment was determined. The following Table 6 shows the results.

**[Table 6]**

| Example | Composition for forming metal-containing film | Baking temperature | Film thickness a | Baking temperature | Film thickness b | (b/a) × 100 | Film thickness c after rinsing | (c/b) × 100 |
|---|---|---|---|---|---|---|---|---|
| | | °C | nm | °C | nm | % | nm | % |
| Example 1-1 | UDL-1 | 100°C | 169.58 | 250°C | 105.14 | 62% | 100.85 | 95.9% |
| Example 1-2 | UDL-2 | 100°C | 147.06 | 250°C | 101.47 | 69% | 101.47 | 100.0% |
| Example 1-3 | UDL-3 | 100°C | 216.09 | 250°C | 99.4 | 46% | 99.13 | 99.7% |
| Example 1-4 | UDL-4 | 100°C | 238.64 | 250°C | 107.39 | 45% | 107.4 | 100.0% |
| Example 1-5 | UDL-5 | 100°C | 207.28 | 250°C | 103.64 | 50% | 103.34 | 99.7% |
| Example 1-6 | UDL-6 | 100°C | 225.81 | 250°C | 97.1 | 43% | 96.7 | 99.6% |
| Example 1-7 | UDL-7 | 100°C | 193.44 | 250°C | 100.59 | 52% | 100.49 | 99.9% |
| Example 1-8 | UDL-8 | 100°C | 189.20 | 250°C | 104.06 | 55% | 104.05 | 100.0% |
| Example 1-9 | UDL-9 | 100°C | 236.60 | 250°C | 99.37 | 42% | 94.77 | 95.4% |
| Example 1-10 | UDL-10 | 100°C | 208.53 | 250°C | 102.18 | 49% | 101.48 | 99.3% |
| Example 1-11 | UDL-11 | 100°C | 200.35 | 250°C | 102.18 | 51% | 100.94 | 98.8% |
| Example 1-12 | UDL-12 | 100°C | 212.88 | 250°C | 102.18 | 48% | 102.19 | 100.0% |
| Example 1-13 | UDL-13 | 100°C | 180.40 | 250°C | 113.65 | 63% | 113.64 | 100.0% |
| Example 1-14 | UDL-14 | 100°C | 209.51 | 250°C | 98.47 | 47% | 98.47 | 100.0% |
| Example 1-15 | UDL-15 | 100°C | 202.60 | 250°C | 105.35 | 52% | 105.35 | 100.0% |
| Comparative Example 1-1 | Comparative UDL-1 | 100°C | 200.59 | 250°C | 3.2 | 20 | - | - |
| Comparative Example 1-2 | Comparative UDL-2 | 100°C | 198.68 | 250°C | 1.8 | 1% | - | - |
| Comparative Example 1-3 | Comparative UDL-3 | 100°C | 176.40 | 250°C | 2.1 | 1% | - | - |
| Comparative Example 1-4 | Comparative UDL-4 | 100°C | 314.35 | 300°C | 81.73 | 26% | 81.75 | 100.0% |
| Comparative Example 1-5 | Comparative UDL-5 | 100°C | 118.21 | 350°C | 92.87 | 21% | 92.87 | 100.0% |

As shown in Table 6, the inventive composition for forming a metal-containing film (Examples 1-1 to 1-15) had a film remaining percentage ((b/a) × 100) of 40% or more after the additional high-temperature baking, and it was shown that the compositions had the high-temperature baking resistance required in resist underlayer films. In addition, the films subjected to additional high-temperature baking had a film remaining percentage ((c/b) × 100) of 95% or more after the PGMEA rinsing, and it can be seen that a crosslinking reaction took place and sufficient solvent resistance was exhibited. In particular, the compounds (UDL-2 to -6, - 8, and -10 to -12), having the structure shown by the general formula (2) had excellent thermosetting property, and showed results of having a film remaining percentage of 99% or more. On the other hand, comparative UDL-1, used in Comparative Example 1-1, did not have a crosslinking group, and therefore, had insufficient heat resistance. Therefore, the film remaining percentage ((b/a) × 100) after the additional high-temperature baking was less than 5%. Meanwhile, heat resistance was also insufficient in the cases of Comparative Examples 1-2 and 1-3, where comparative UDL-2 and comparative UDL-3 were used. Comparative UDL-2 and comparative UDL-3 had the same terminal crosslinking group as the inventive compounds, but had an organic group different from the general formula (1). In these cases, the film remaining after the high-temperature baking was less than 5 nm.

In Comparative Example 1-4, the used composition comparative UDL-4 contained, as a compound having a different metal from the inventive compound for forming a metal-containing film, the titanium compound reported in [Synthesis Example A-II] of JP6189758B2. In this case, sufficient solvent resistance was exhibited, but the difference between the film thicknesses before and after the additional high-temperature baking was large, and it was shown that volume shrinkage due to high-temperature baking was greater than in the inventive compound for forming a metal-containing film.

### [Filling Property Evaluation (Examples 2-1 to 2-15 and Comparative Examples 2-1 and 2-2)]

Each of the compositions (UDL-1 to -15 and comparative UDL-4 and -5) for forming a metal-containing film that had favorable film-formability after the additional baking in the solvent resistance evaluation was respectively applied onto an SiO₂ wafer substrate having a dense line-and-space pattern (line width = 40 nm, line depth = 120 nm, distance between the centers of two adjacent lines = 80 nm), followed by heating at the temperature shown in Table 7 for 60 seconds by using a hot plate to form a metal-containing film having a film thickness of 100 nm. The substrate used was a base substrate 9 (SiO₂ wafer substrate) having a dense line-and-space pattern shown in FIG. 3(Q) (downward view) and (R) (cross-sectional view). The cross-sectional shape of each of the obtained wafer substrates was observed using an electron microscope (S-4700: manufactured by Hitachi, Ltd.), and the presence/absence of voids (gaps) inside the metal-containing film filling the space between the lines was confirmed. Table 7 shows the results. In this evaluation, when a composition for forming a metal-containing film having a poor filling property is used, voids are generated inside the metal-containing film filling the space between the lines. In this evaluation, when a composition for forming a metal-containing film having a desirable filling property is used, as shown in FIG. 3(S), the inside of the metal-containing film filling the space between the lines of the base substrate 9 having the dense line-and-space pattern is filled with a void-free metal-containing film 10.

**[Table 7]**

| Example | Composition for forming metal-containing film | Baking temperature | Filling property Voids |
|---|---|---|---|
| | | °C | |
| Example 2-1 | UDL-1 | 250°C | Absent |
| Example 2-2 | UDL-2 | 250°C | Absent |
| Example 2-3 | UDL-3 | 250°C | Absent |
| Example 2-4 | UDL-4 | 250°C | Absent |
| Example 2-5 | UDL-5 | 250°C | Absent |
| Example 2-6 | UDL-6 | 250°C | Absent |
| Example 2-7 | UDL-7 | 250°C | Absent |
| Example 2-8 | UDL-8 | 250°C | Absent |
| Example 2-9 | UDL-9 | 250°C | Absent |
| Example 2-10 | UDL-10 | 250°C | Absent |
| Example 2-11 | UDL-11 | 250°C | Absent |
| Example 2-12 | UDL-12 | 250°C | Absent |
| Example 2-13 | UDL-13 | 250°C | Absent |
| Example 2-14 | UDL-14 | 250°C | Absent |
| Example 2-15 | UDL-15 | 250°C | Absent |
| Comparative Example 2-1 | Comparative UDL-4 | 300°C | Present |
| Comparative Example 2-2 | Comparative UDL-5 | 300°C | Absent |

It was successfully confirmed that, as shown in Table 7, in Examples 2-1 to 2-15 using the inventive compositions (UDL-1 to -15) for forming a metal-containing film, it was possible to fill the dense line-and-space pattern without the generation of voids, and excellent filling property was provided. On the other hand, voids were observed at the bottom of the pattern in Comparative Example 2-1, using comparative UDL-4 containing the titanium compound reported in [Synthesis Example A-II] of JP6189758B2. It is conjectured that voids were generated because volume shrinkage due to high-temperature baking was great, as observed in the solvent resistance evaluation. Meanwhile, in Comparative Example 2-2, where comparative UDL-5 was used, no voids were generated.

### [Planarizing Property Evaluation (Examples 3-1 to 3-15 and Comparative Examples 3-1 and 3-2)]

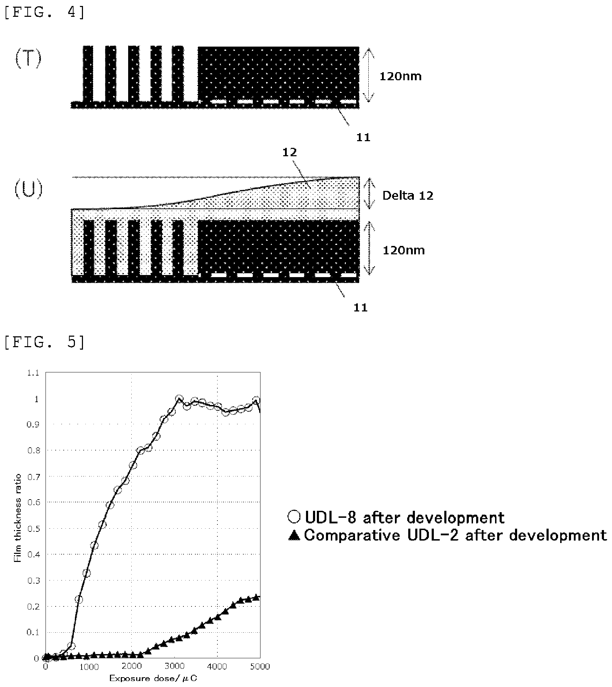

Regarding base substrates 11 (SiO₂ wafer substrates) each having a dense line-and-space pattern shown in FIG. 4(T), the cross sectional shape of each of the wafer substrates obtained in the filling property evaluation as shown in FIG. 4(U) was observed using a scanning electron microscope (SEM), and the step Delta 12 between the line-pattern-dense portion and the non-line-pattern portion of the filling film 12 was observed using an electron microscope (S-4700: manufactured by Hitachi, Ltd.). Table 8 shows the results. In the present evaluation, it can be said that the smaller the step, the better the planarizing property.

**[Table 8]**

| Example | Composition for forming metal-containing film | Baking temperature | Flatness |
|---|---|---|---|
| | | °C | nm |
| Example 3-1 | UDL-1 | 250°C | 35 |
| Example 3-2 | UDL-2 | 250°C | 34 |
| Example 3-3 | UDL-3 | 250°C | 28 |
| Example 3-4 | UDL-4 | 250°C | 30 |
| Example 3-5 | UDL-5 | 250°C | 28 |
| Example 3-6 | UDL-6 | 250°C | 29 |
| Example 3-7 | UDL-7 | 250°C | 29 |
| Example 3-8 | UDL-8 | 250°C | 26 |
| Example 3-9 | UDL-9 | 250°C | 31 |
| Example 3-10 | UDL-10 | 250°C | 29 |
| Example 3-11 | UDL-11 | 250°C | 30 |
| Example 3-12 | UDL-12 | 250°C | 27 |
| Example 3-13 | UDL-13 | 250°C | 24 |
| Example 3-14 | UDL-14 | 250°C | 23 |
| Example 3-15 | UDL-15 | 250°C | 27 |
| Comparative Example 3-1 | Comparative UDL-4 | 300°C | 57 |
| Comparative Example 3-2 | Comparative UDL-5 | 350°C | 49 |

As shown in Table 8, it was observed that the step in the film between the patterned portion and the non-patterned portion was small and the planarization property was better in Examples 3-1 to 3-15, where the inventive compositions (UDL-1 to -15) for forming a metal-containing film were used, than in Comparative Example 3-2, where the organic resist underlayer film material, comparative UDL-5, was used. In particular, it was observed that excellent planarizing property was exhibited by the components containing a compound having one of the structures shown by the general formulae (a-1) to (a-3) in the terminal crosslinking groups. For example, comparing UDL-2, which contained the compound (A-2) having hydroxy groups, with UDL-3, which contained the compound (A-3) having crosslinking groups having the structure shown by (a-3), UDL-3 exhibited a better planarizing property. In other words, it can be observed that thermal flowability is improved and excellent planarizing property is exhibited when one of the structures shown by the general formulae (a-1) to (a-3) is included in the terminal crosslinking groups.

Furthermore, UDL-13, which contained a flowability accelerator (BP-1), and UDL-14, which contained a high-boiling-point solvent (D-1), showed particularly excellent planarizing property. It can be observed that the thermal flowability of a compound for forming a metal-containing film can be improved further by using these additives.

Meanwhile, in Comparative Example 3-1, where comparative UDL-4 was used, flatness was poor.

### [Etching Resistance Evaluation (Examples 4-1 to 4-15 and Comparative Examples 4-1 and 4-2)]

Each of the compositions (UDL-1 to -15 and comparative UDL-4 and -5) for forming a metal-containing film that had good film-formability after the additional baking in the solvent resistance evaluation was respectively applied onto a silicon substrate and heated by using a hot plate at the temperature shown in Table 9 for 60 seconds to form a metal-containing film having a film thickness of 100 nm, and the film thickness A was measured. Subsequently, etching was performed with CF₄ gas, O₂ gas, and Cl₂ gas under the following conditions for the specified number of seconds by using an etching apparatus CE-300I manufactured by ULVAC, Inc., and the film thickness B was measured. Then, the film thickness etched in 1 minute ("film thickness A" - "film thickness B") was calculated. Table 9 shows the results.

Conditions of dry etching with CF₄ gas
Pressure: 1 Pa
Antenna RF power: 100 W
Bias RF power: 15 W
CF₄ gas flow rate: 15 sccm
Time: 30 sec

Conditions of dry etching with O₂ gas
Pressure: 1 Pa
Antenna RF power: 300 W
Bias RF power: 0 W
O₂ gas flow rate: 25 sccm
Time: 20 sec

Conditions of dry etching with Cl₂ gas
Pressure: 1 Pa
Antenna RF power: 320 W
Bias RF power: 30 W
Cl₂ gas flow rate: 25 sccm
Time: 10 sec

**[Table 9]**

| Example | Composition for forming metal-containing film | Baking temperature | Etching resistance (nm/min) | Etching resistance (nm/min) | Etching resistance (nm/min) |
|---|---|---|---|---|---|
| | | °C | CF₄ | O₂ | Cl₂ |
| Example 4-1 | UDL-1 | 250°C | 31 | 8 | 530 |
| Example 4-2 | UDL-2 | 250°C | 29 | 7 | 520 |
| Example 4-3 | UDL-3 | 250°C | 28 | 7 | 520 |
| Example 4-4 | UDL-4 | 250°C | 28 | 10 | 510 |
| Example 4-5 | UDL-5 | 250°C | 28 | 7 | 520 |
| Example 4-6 | UDL-6 | 250°C | 29 | 8 | 520 |
| Example 4-7 | UDL-7 | 250°C | 27 | 5 | 510 |
| Example 4-8 | UDL-8 | 250°C | 27 | 5 | 510 |
| Example 4-9 | UDL-9 | 250°C | 29 | 8 | 520 |
| Example 4-10 | UDL-10 | 250°C | 27 | 5 | 510 |
| Example 4-11 | UDL-11 | 250°C | 30 | 8 | 530 |
| Example 4-12 | UDL-12 | 250°C | 31 | 7 | 550 |
| Example 4-13 | UDL-13 | 250°C | 36 | 12 | 500 |
| Example 4-14 | UDL-14 | 250°C | 27 | 5 | 510 |
| Example 4-15 | UDL-15 | 250°C | 30 | 6 | 550 |
| Comparative Example 4-1 | Comparative UDL-4 | 300°C | 30 | 10 | 105 |
| Comparative Example 4-2 | Comparative UDL-5 | 350°C | 65 | 210 | 130 |

As shown in Table 9, it was shown that better CF₄ etching resistance and O₂ etching resistance were exhibited in Examples 4-1 to 4-15, where the inventive compositions (UDL-1 to -15) for forming a metal-containing film were used, than in Comparative Example 4-2, where comparative UDL-5, which is an organic resist underlayer film material, was used. In addition, it was revealed that, while the compositions showed excellent resistance to etching with CF₄ gas and O₂ gas, the compositions exhibited excellent removability by etching with Cl₂ gas. Comparative Example 4-1, where comparative UDL-4 was used, the composition showed excellent etching resistance.

### [Patterning Process (Examples 5-1 to 5-15 and Comparative Examples 5-1 and 5-2)]

Each of the compositions (UDL-1 to -15 and comparative UDL-4 and -5) for forming a metal-containing film that had favorable film-formability after the additional baking in the solvent resistance evaluation was respectively applied onto an SiOz wafer substrate having a trench pattern (trench width: 10 um, trench depth: 0.10 um), and baked at 250°C for 60 seconds in the atmosphere to form a metal-containing film having a thickness of 100 nm. A silicon-containing resist middle layer film material (SOG-1) was applied thereto, followed by baking at 220°C for 60 seconds to form a resist middle layer film having a thickness of 35 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to a photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 10; and filtering the solution through a filter made of a fluororesin and having a pore size of 0.1 µm.

**[Table 10]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The polymer (SiP1) and the thermal crosslinking catalyst (CAT1) used in the silicon-containing resist middle layer film material (SOG-1) are shown below.

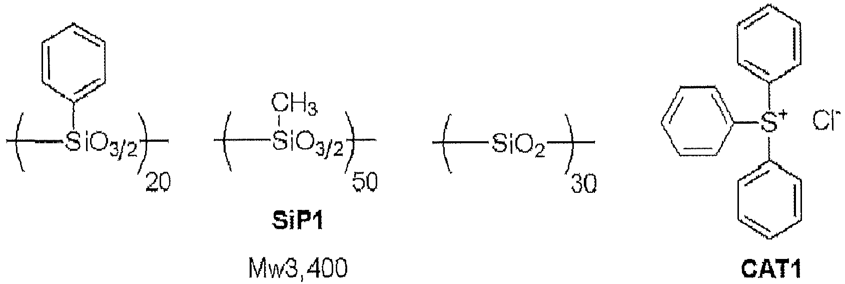

The resist upper layer film material (monolayer resist for ArF) was prepared by dissolving a polymer (RP1), an acid generator (PAG1), and a basic compound (Amine1), each in the proportion shown in Table 11, in a solvent containing 0.1% by mass of a surfactant (FC-4430: manufactured by Sumitomo 3M Limited), and filtering the solution through a 0.1-µm filter made of a fluororesin.

**[Table 11]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

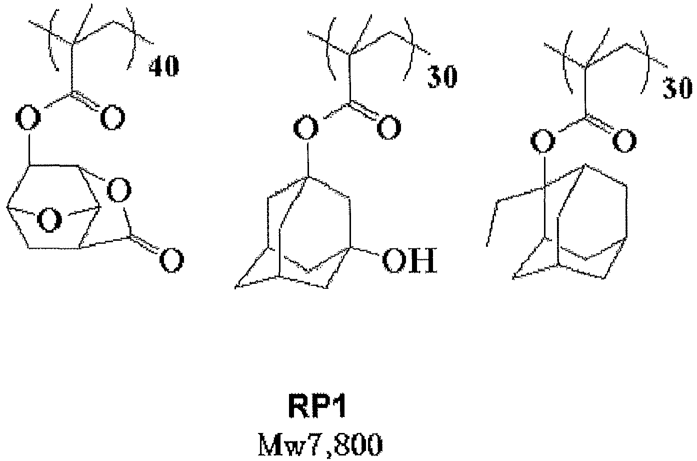

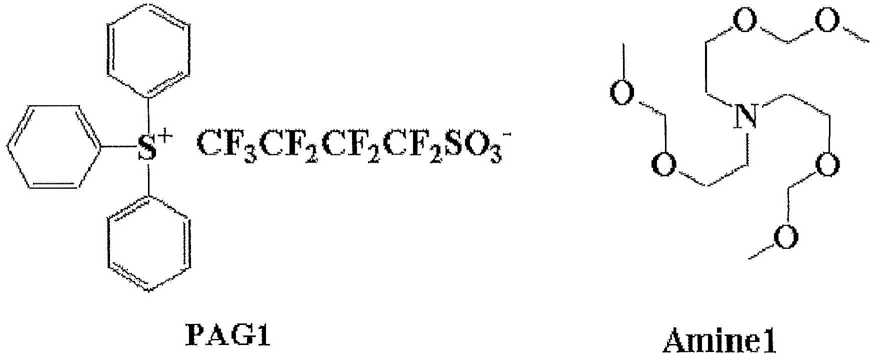

The liquid immersion top coat composition (TC-1) was prepared by dissolving a top coat polymer (PP1) in an organic solvent at the proportion shown in Table 12, and filtering the solution through a 0.1-µm filter made of a fluororesin.

**[Table 12]**

| | Top coat polymer (parts by mass) | Organic solvent (parts by mass) |
|---|---|---|
| TC-1 | PP1 (100) | Diisoamyl ether (2,700) 2-methyl-1-butanol (270) |

The top coat polymer (PP1) used for the liquid immersion top coat composition (TC-1) is shown below.

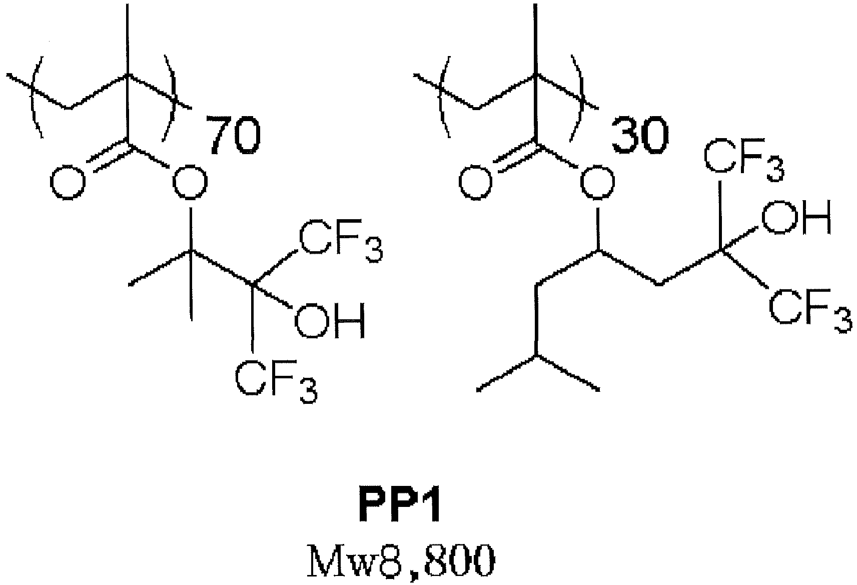

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38 % by mass of tetramethylammonium hydroxide (TMAH) aqueous solution for 30 seconds, thereby obtaining a 55 nm 1:1 positive line-and-space pattern (a resist pattern).

Subsequently, the resist middle layer film was etched by dry etching while using the resist pattern as a mask to form a hard mask pattern. A metal-containing film was then etched while using the obtained hard mask pattern as a mask to form a metal-containing film pattern, and the SiO₂ film was etched while using the obtained metal-containing film pattern as a mask. The etching conditions were as follows.

Conditions in transferring resist pattern to resist middle layer film
Conditions of dry etching with CF₄ gas
Pressure: 1 Pa
Antenna RF power: 100 W
Bias RF power: 15 W
CF₄ gas flow rate: 15 sccm
Time: 60 sec

Conditions in transferring hard mask pattern to metal-containing film
Conditions of dry etching with Cl₂ gas
Pressure: 1 Pa
Antenna RF power: 320 W
Bias RF power: 30 W
Cl₂ gas flow rate: 25 sccm
Time (Example 5-1 to Example 5-15): 15 sec
Time (Comparative Example 5-1 and Comparative Example 5-2): 60 sec

Conditions in transferring metal-containing film pattern to SiO₂ film
Conditions of dry etching with CF₄ gas
Pressure: 1 Pa
Antenna RF power: 100 W
Bias RF power: 15 W
CF₄ gas flow rate: 15 sccm
Time: 100 sec

Table 13 shows the results obtained by observation of the pattern cross section with an electron microscope (S-4700) manufactured by Hitachi, Ltd.

**[Table 13]**

| Example | Composition for forming metal-containing film | Pattern profile after etching for transferring to substrate |
|---|---|---|
| Example 5-1 | UDL-1 | Vertical profile |
| Example 5-2 | UDL-2 | Vertical profile |
| Example 5-3 | UDL-3 | Vertical profile |
| Example 5-4 | UDL-4 | Vertical profile |
| Example 5-5 | UDL-5 | Vertical profile |
| Example 5-6 | UDL-6 | Vertical profile |
| Example 5-7 | UDL-7 | Vertical profile |
| Example 5-8 | UDL-8 | Vertical profile |
| Example 5-9 | UDL-9 | Vertical profile |
| Example 5-10 | UDL-10 | Vertical profile |
| Example 5-11 | UDL-11 | Vertical profile |
| Example 5-12 | UDL-12 | Vertical profile |
| Example 5-13 | UDL-13 | Vertical profile |
| Example 5-14 | UDL-14 | Vertical profile |
| Example 5-15 | UDL-15 | Vertical profile |
| Comparative Example 5-1 | Comparative UDL-4 | Pattern collapse |
| Comparative Example 5-2 | Comparative UDL-5 | Distorted pattern |

As shown in Table 13, in Examples 5-1 to 5-15, where the inventive compositions (UDL-1 to -15) for forming a metal-containing film were used, the resist upper layer film pattern was successfully transferred to the substrate in the end in every case. Thus, it was confirmed that the inventive composition for forming a metal-containing film can be used suitably for fine processing using a multilayer resist method. On the other hand, in Comparative Example 5-1, where comparative UDL-4, in which the performance in the filling property evaluation and the planarizing property evaluation was found to be insufficient, was used, pattern collapse occurred during patterning, and it was not possible to obtain a favorable pattern in the end. Meanwhile, in Comparative Example 5-2, where comparative UDL-5, in which there were no problems in the filling property and planarizing property evaluations but insufficient performance was observed in the dry etching resistance evaluation, was used, distortion of the pattern profile occurred at the time of pattern processing, and it was not possible to obtain a favorable pattern in the end.

### [Evaluation of Electron Beam Exposure]

Each of UDL-8 and comparative UDL-2 was respectively applied onto a silicon wafer substrate as the composition for forming a metal-containing film and baked at 100°C for 60 seconds to form a metal-containing film with a thickness of 40 nm.

Subsequently, drawing in a vacuum chamber was performed by using ELS-F125 (manufactured by Elionix Inc.) at an acceleration voltage of 125 kV while altering the exposure dose. Then, immediately after drawing, baking (PEB) was performed at 100°C for 60 seconds, and paddle development was performed with 2-heptanone for 30 seconds to obtain a contrast curve of a negative resist. FIG. 5 shows the results.

In the case of UDL-8, where the inventive composition for forming a metal-containing film was used, it was observed that solubility in the developer decreased as the exposure dose increased. On the other hand, in the case of comparative UDL-2, the film was not sufficiently insolubilized by the increase in exposure dose.

From the above, the inventive compound for forming a metal-containing film is an organotin compound having both high thermal flowability and high thermosetting property, so that a composition for forming a metal-containing film containing the compound can provide a resist underlayer film material having better dry etching resistance than conventional resist underlayer film materials and also having high filling and planarizing properties. Therefore, such a composition is extremely useful as a resist underlayer film material used in a multilayer resist method and an inverting agent used in a tone-reversal etching method. Moreover, it was revealed that, since the composition had excellent curability, it was possible to provide a metal-containing resist material having high sensitivity and high resolution in EUV and electron beam lithography when the above-described compound is used in a resist material.

The present description includes the following embodiments.
[1]: A compound for forming a metal-containing film to be contained in a composition for forming a metal-containing film used in manufacturing a semiconductor, wherein the compound for forming a metal-containing film is represented by the following general formula (M-1) or (M-2), 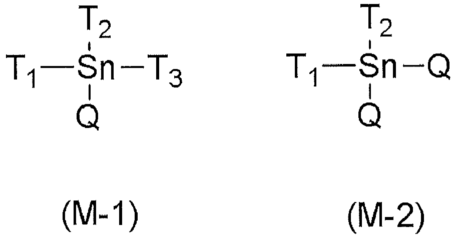 wherein T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 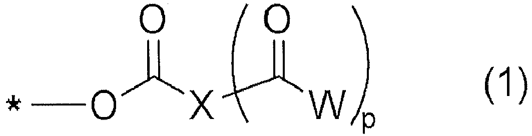 wherein X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom, 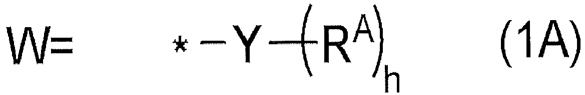 wherein Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point, 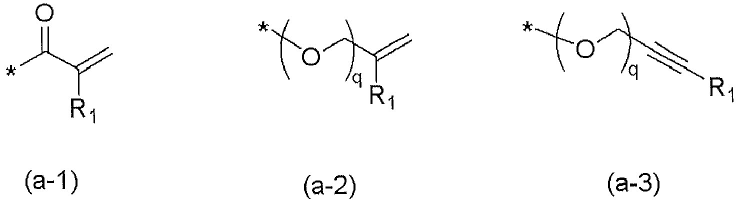 wherein R₁ represents a hydrogen atom or a monovalent organic group having 1 to 10 carbon atoms; "q" represents 0 or 1; and "*" represents an attachment point to Y.
[2]: The compound for forming a metal-containing film of the above [1], wherein the W in the general formula (1) has a structure represented by the following general formula (1B), 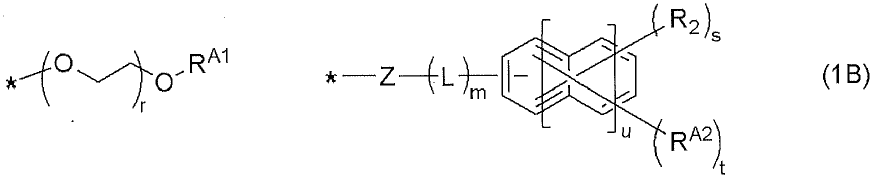 wherein R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "t" represents 1 to 6; "s" represents 0 to 5; t+s is 1 or more and 6 or less; "r" represents 1 to 10; "u" represents 0 or 1; "m" represents 0 or 1; and "*" represents an attachment point.
[3]: The compound for forming a metal-containing film of the above [1] or [2], wherein the X in the general formula (1) represents an unsaturated hydrocarbon having 2 to 20 carbon atoms.
[4]: The compound for forming a metal-containing film of any one of the above [1] to [3], represented by the following general formula (2), 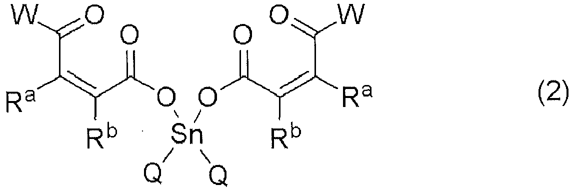 wherein R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto; and Q and W are as defined above.
[5]: The compound for forming a metal-containing film of any one of the above [1] to [4], wherein the compound for forming a metal-containing film satisfies 1.00 ≤ Mw/Mn ≤ 1.30, where Mw is a weight-average molecular weight and Mn is a number-average molecular weight measured by gel permeation chromatography in terms of polystyrene.
[6]: A composition for forming a metal-containing film, the composition functioning as a resist underlayer film material and/or a resist material used in manufacturing a semiconductor, the composition comprising: (A) the compound for forming a metal-containing film of any one of the above [1] to [5]; and (B) an organic solvent.
[7]: The composition for forming a metal-containing film of the above [6], wherein the composition for forming a metal-containing film is usable as a resist underlayer film used in a multilayer resist method, the composition further comprising one or more of (C) a crosslinking agent, (D) a high-boiling-point solvent, (E) a surfactant, and (F) a flowability accelerator.
[8]: The composition for forming a metal-containing film of the above [7], wherein the high-boiling-point solvent (D) is one or more kinds of organic solvent having a boiling point of 180°C or higher.
[9]: The composition for forming a metal-containing film of any one of the above [6] to [8], further comprising (G) metal oxide nanoparticles having an average primary particle size of 100 nm or less.
[10]: The composition for forming a metal-containing film of the above [9], wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.
[11]: A patterning process for forming a pattern in a substrate to be processed, comprising the steps of:
   (I-1) applying the composition for forming a metal-containing film of any one of the above [6] to [10] onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
[12]: A patterning process for forming a pattern in a substrate to be processed, comprising the steps of:
   (II-1) applying the composition for forming a metal-containing film of any one of the above [6] to [10] onto a substrate to be processed, followed by heating to form a metal-containing film;
   (II-2) forming a resist middle layer film on the metal-containing film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal-containing film by dry etching while using the resist middle layer film having the transferred pattern as a mask; and
   (II-7) processing the substrate to be processed while using the metal-containing film having the formed pattern as a mask to form the pattern in the substrate to be processed.
[13]: A patterning process for forming a pattern in a substrate to be processed, comprising the steps of:
   (III-1) applying the composition for forming a metal-containing film of any one of the above [6] to [10] onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
[14]: The patterning process of the above [13], wherein the inorganic hard mask middle layer film is formed by a CVD method or an ALD method.
[15]: A patterning process for forming a pattern in a substrate to be processed, comprising the steps of:
   (IV-1) forming a resist underlayer film on a substrate to be processed;
   (IV-2) applying the composition for forming a metal-containing film of any one of the above [6] to [10] onto the resist underlayer film, followed by heating to form a metal-containing film;
   (IV-3) forming a resist upper layer film on the metal-containing film by using a photoresist material;
   (IV-4) subjecting the resist upper layer film to pattern exposure and then development with a developer to form a pattern in the resist upper layer film;
   (IV-5) transferring the pattern to the metal-containing film by dry etching while using the resist upper layer film having the formed pattern as a mask;
   (IV-6) transferring the pattern to the resist underlayer film by dry etching while using the metal-containing film having the transferred pattern as a mask; and
   (IV-7) processing the substrate to be processed while using the resist underlayer film having the formed pattern as a mask to form the pattern in the substrate to be processed.
[16]: A patterning process for forming a pattern in a substrate to be processed, comprising the steps of:
   (V-1) forming a resist underlayer film on a substrate to be processed;
   (V-2) forming a resist middle layer film or a combination of an inorganic hard mask middle layer film selected from a silicon oxide film, a silicon nitride film, and a silicon oxynitride film and an organic thin film on the resist underlayer film;
   (V-3) forming a resist upper layer film on the resist middle layer film or the combination of the inorganic hard mask middle layer film and the organic thin film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film of any one of the above [6] to [10] onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.
[17]: A patterning process comprising the steps of:
   applying the composition for forming a metal-containing film of any one of the above [6] to [10] onto a substrate, followed by heating to form a resist film;
   exposing the resist film to a high-energy beam; and
   developing the exposed resist film by using a developer.
[18]: The patterning process of the above [17], wherein an organic solvent is used as the developer.
[19]: The patterning process of the above [18], wherein the developer is one or more organic solvents selected from 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.
[20]: The patterning process of any one of the above [17] to [19], wherein an extreme ultraviolet ray having a wavelength of 3 to 15 nm is used as the high-energy beam.
[21]: The patterning process of any one of the above [17] to [19], wherein an electron beam having an acceleration voltage of 1 to 250 kV is used as the high-energy beam.
[22]: A semiconductor photoresist material, wherein the semiconductor photoresist material is the composition for forming a metal-containing film of any one of the above [6] to [10] further comprising (H) a photo-acid generator.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.
The present invention also refers to the following embodiments, wherein the term "claim" means embodiment.
1. A compound for forming a metal-containing film to be contained in a composition for forming a metal-containing film used in manufacturing a semiconductor, wherein the compound for forming a metal-containing film is represented by the following general formula (M-1) or (M-2), 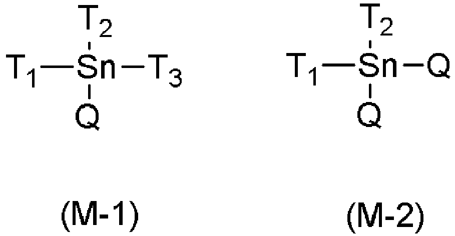 wherein T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 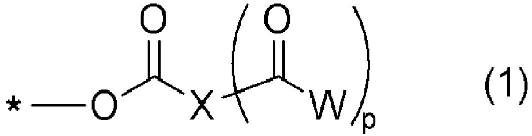 wherein X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom, 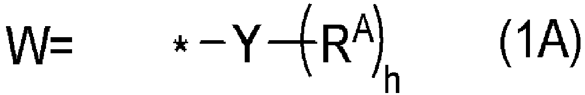 wherein Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point, 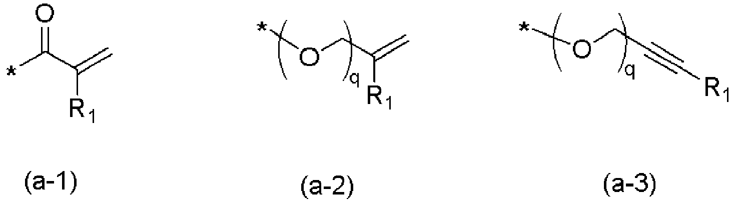 wherein R₁ represents a hydrogen atom or a monovalent organic group having 1 to 10 carbon atoms; "q" represents 0 or 1; and "*" represents an attachment point to Y.
2. The compound for forming a metal-containing film according to claim 1, wherein the W in the general formula (1) has a structure represented by the following general formula (1B), 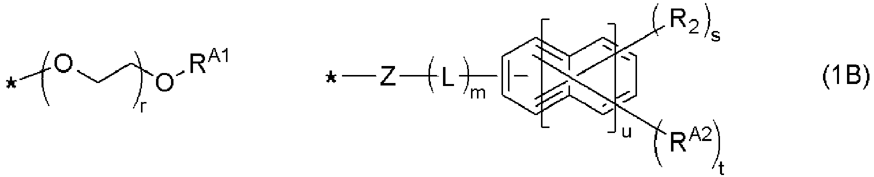 wherein R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "t" represents 1 to 6; "s" represents 0 to 5; t+s is 1 or more and 6 or less; "r" represents 1 to 10; "u" represents 0 or 1; "m" represents 0 or 1; and "*" represents an attachment point.
3. The compound for forming a metal-containing film according to claim 1 or 2, wherein the X in the general formula (1) represents an unsaturated hydrocarbon having 2 to 20 carbon atoms.
4. The compound for forming a metal-containing film according to any one of claims 1 to 3, represented by the following general formula (2), 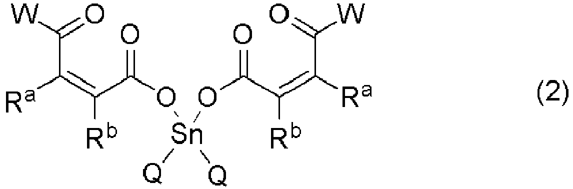 wherein R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto; and Q and W are as defined above.
5. The compound for forming a metal-containing film according to any one of claims 1 to 4, wherein the compound for forming a metal-containing film satisfies 1.00 ≤ Mw/Mn ≤ 1.30, where Mw is a weight-average molecular weight and Mn is a number-average molecular weight measured by gel permeation chromatography in terms of polystyrene.
6. A composition for forming a metal-containing film, the composition functioning as a resist underlayer film material and/or a resist material used in manufacturing a semiconductor, the composition comprising: (A) the compound for forming a metal-containing film according to any one of claims 1 to 5; and (B) an organic solvent.
7. The composition for forming a metal-containing film according to claim 6, wherein the composition for forming a metal-containing film is usable as a resist underlayer film used in a multilayer resist method, the composition further comprising one or more of (C) a crosslinking agent, (D) a high-boiling-point solvent, (E) a surfactant, and (F) a flowability accelerator.
8. The composition for forming a metal-containing film according to claim 7, wherein the high-boiling-point solvent (D) is one or more kinds of organic solvent having a boiling point of 180°C or higher.
9. The composition for forming a metal-containing film according to any one of claims 6 to 8, further comprising (G) metal oxide nanoparticles having an average primary particle size of 100 nm or less.
10. The composition for forming a metal-containing film according to claim 9, wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.
11. A patterning process for forming a pattern in a substrate to be processed, comprising the steps of:
   (I-1) applying the composition for forming a metal-containing film according to any one of claims 6 to 10 onto a substrate to be processed, followed by heating to form a metal-containing film;
   (I-2) forming a resist upper layer film on the metal-containing film by using a photoresist material;
   (I-3) subjecting the resist upper layer film to pattern exposure and then development with a developer to form a pattern in the resist upper layer film;
   (I-4) transferring the pattern to the metal-containing film by dry etching while using the resist upper layer film having the formed pattern as a mask; and
   (I-5) processing the substrate to be processed while using the metal-containing film having the formed pattern as a mask to form the pattern in the substrate to be processed.
12. A patterning process for forming a pattern in a substrate to be processed, comprising the steps of:
   (II-1) applying the composition for forming a metal-containing film according to any one of claims 6 to 10 onto a substrate to be processed, followed by heating to form a metal-containing film;
   (II-2) forming a resist middle layer film on the metal-containing film;
   (II-3) forming a resist upper layer film on the resist middle layer film by using a photoresist material;
   (II-4) subjecting the resist upper layer film to pattern exposure and then development with a developer to form a pattern in the resist upper layer film;
   (II-5) transferring the pattern to the resist middle layer film by dry etching while using the resist upper layer film having the formed pattern as a mask;
   (II-6) transferring the pattern to the metal-containing film by dry etching while using the resist middle layer film having the transferred pattern as a mask; and
   (II-7) processing the substrate to be processed while using the metal-containing film having the formed pattern as a mask to form the pattern in the substrate to be processed.
13. A patterning process for forming a pattern in a substrate to be processed, comprising the steps of:
   (III-1) applying the composition for forming a metal-containing film according to any one of claims 6 to 10 onto a substrate to be processed, followed by heating to form a metal-containing film;
   (III-2) forming an inorganic hard mask middle layer film selected from a silicon oxide film, a silicon nitride film, and a silicon oxynitride film on the metal-containing film;
   (III-3) forming an organic thin film on the inorganic hard mask middle layer film;
   (III-4) forming a resist upper layer film on the organic thin film by using a photoresist material;
   (III-5) subjecting the resist upper layer film to pattern exposure and then development with a developer to form a pattern in the resist upper layer film;
   (III-6) transferring the pattern to the organic thin film and the inorganic hard mask middle layer film by dry etching while using the resist upper layer film having the formed pattern as a mask;
   (III-7) transferring the pattern to the metal-containing film by dry etching while using the inorganic hard mask middle layer film having the transferred pattern as a mask; and
   (III-8) processing the substrate to be processed while using the metal-containing film having the formed pattern as a mask to form the pattern in the substrate to be processed.
14. The patterning process according to claim 13, wherein the inorganic hard mask middle layer film is formed by a CVD method or an ALD method.
15. A patterning process for forming a pattern in a substrate to be processed, comprising the steps of:
   (IV-1) forming a resist underlayer film on a substrate to be processed;
   (IV-2) applying the composition for forming a metal-containing film according to any one of claims 6 to 10 onto the resist underlayer film, followed by heating to form a metal-containing film;
   (IV-3) forming a resist upper layer film on the metal-containing film by using a photoresist material;
   (IV-4) subjecting the resist upper layer film to pattern exposure and then development with a developer to form a pattern in the resist upper layer film;
   (IV-5) transferring the pattern to the metal-containing film by dry etching while using the resist upper layer film having the formed pattern as a mask;
   (IV-6) transferring the pattern to the resist underlayer film by dry etching while using the metal-containing film having the transferred pattern as a mask; and
   (IV-7) processing the substrate to be processed while using the resist underlayer film having the formed pattern as a mask to form the pattern in the substrate to be processed.
16. A patterning process for forming a pattern in a substrate to be processed, comprising the steps of:
   (V-1) forming a resist underlayer film on a substrate to be processed;
   (V-2) forming a resist middle layer film or a combination of an inorganic hard mask middle layer film selected from a silicon oxide film, a silicon nitride film, and a silicon oxynitride film and an organic thin film on the resist underlayer film;
   (V-3) forming a resist upper layer film on the resist middle layer film or the combination of the inorganic hard mask middle layer film and the organic thin film by using a photoresist material;
   (V-4) subjecting the resist upper layer film to pattern exposure and then development with a developer to form a pattern in the resist upper layer film;
   (V-5) transferring the pattern to the resist middle layer film or the organic thin film and the inorganic hard mask middle layer film by dry etching while using the resist upper layer film having the formed pattern as a mask;
   (V-6) transferring the pattern to the resist underlayer film by dry etching while using the resist middle layer film or the inorganic hard mask middle layer film having the transferred pattern as a mask;
   (V-7) applying the composition for forming a metal-containing film according to any one of claims 6 to 10 onto the resist underlayer film having the formed pattern, followed by heating to cover the resist underlayer film with a metal-containing film, thereby filling a space between the resist underlayer film patterns with the metal-containing film;
   (V-8) etching back the metal-containing film covering the resist underlayer film having the formed pattern by a chemical stripper or dry etching to expose an upper surface of the resist underlayer film having the formed pattern;
   (V-9) removing the resist middle layer film or the inorganic hard mask middle layer film remaining on the upper surface of the resist underlayer film by dry etching;
   (V-10) removing the resist underlayer film having the formed pattern with its surface exposed by dry etching to form a reverse pattern of an original pattern on the metal-containing film; and
   (V-11) processing the substrate to be processed while using the metal-containing film having the formed reverse pattern as a mask to form the reverse pattern in the substrate to be processed.
17. A patterning process comprising the steps of:
   applying the composition for forming a metal-containing film according to any one of claims 6 to 10 onto a substrate, followed by heating to form a resist film;
   exposing the resist film to a high-energy beam;
      and
   developing the exposed resist film by using a developer.
18. The patterning process according to claim 17, wherein an organic solvent is used as the developer.
19. The patterning process according to claim 18, wherein the developer is one or more organic solvents selected from 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.
20. The patterning process according to any one of claims 17 to 19, wherein an extreme ultraviolet ray having a wavelength of 3 to 15 nm is used as the high-energy beam.
21. The patterning process according to any one of claims 17 to 19, wherein an electron beam having an acceleration voltage of 1 to 250 kV is used as the high-energy beam.
22. A semiconductor photoresist material, wherein the semiconductor photoresist material is the composition for forming a metal-containing film according to any one of claims 6 to 10 further comprising (H) a photo-acid generator.

## Claims

1. A compound for forming a metal-containing film to be contained in a composition for forming a metal-containing film used in manufacturing a semiconductor, wherein the compound for forming a metal-containing film is represented by the following general formula (M-1) or (M-2), 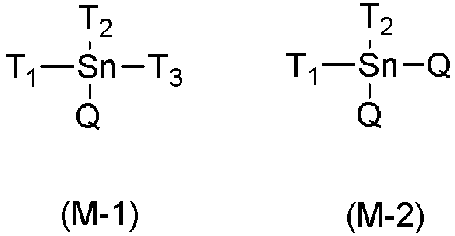 wherein T₁, T₂, and T₃ represent the following general formula (1) and are identical to or different from one another; and Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups, 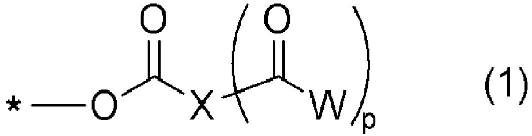 wherein X represents a saturated divalent organic group having 1 to 20 carbon atoms, an unsaturated divalent organic group having 2 to 20 carbon atoms, a saturated trivalent organic group having 1 to 20 carbon atoms, or an unsaturated trivalent organic group having 2 to 20 carbon atoms; W represents the following general formula (1A); "p" represents 1 or 2; and "*" represents an attachment point to an Sn atom, 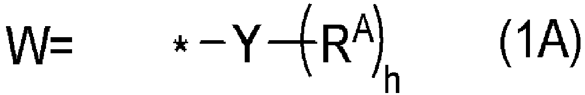 wherein Y represents a saturated divalent organic group having 1 to 20 carbon atoms and optionally being substituted with a heteroatom or an unsaturated divalent organic group having 2 to 20 carbon atoms and optionally being substituted with a heteroatom; R^{A} represents a hydroxy group or a structure represented by one of the following general formulae (a-1) to (a-3); "h" represents 1 to 6; and "*" represents an attachment point, 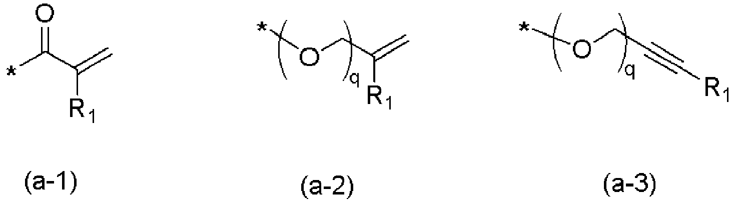 wherein R₁ represents a hydrogen atom or a monovalent organic group having 1 to 10 carbon atoms; "q" represents 0 or 1; and "*" represents an attachment point to Y.

2. The compound for forming a metal-containing film according to claim 1, wherein the W in the general formula (1) has a structure represented by the following general formula (1B), 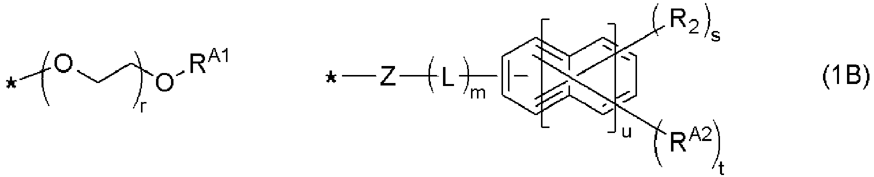 wherein R^{A1} represents a structure represented by the general formula (a-1); R^{A2} represents a hydroxy group or one of the structures represented by the general formulae (a-2) and (a-3); Z represents an oxygen atom or a secondary amine; L represents a divalent hydrocarbon group having 1 to 10 carbon atoms; R₂ represents a saturated divalent organic group having 1 to 20 carbon atoms or an unsaturated divalent organic group having 2 to 20 carbon atoms; "t" represents 1 to 6; "s" represents 0 to 5; t+s is 1 or more and 6 or less; "r" represents 1 to 10; "u" represents 0 or 1; "m" represents 0 or 1; and "*" represents an attachment point.

3. The compound for forming a metal-containing film according to claim 1 or 2, wherein the X in the general formula (1) represents an unsaturated hydrocarbon having 2 to 20 carbon atoms.

4. The compound for forming a metal-containing film according to any one of claims 1 to 3, represented by the following general formula (2), 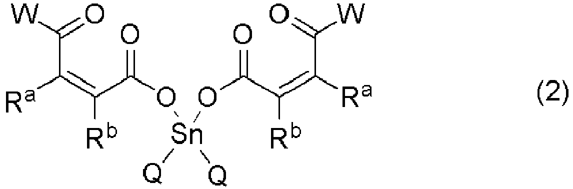 wherein R^{a} and R^{b} represent a hydrogen atom or a monovalent organic group having 1 to 20 carbon atoms, R^{a} and R^{b} optionally being bonded to each other to form a cyclic substituent together with carbon atoms bonded thereto; and Q and W are as defined above.

5. The compound for forming a metal-containing film according to any one of claims 1 to 4, wherein the compound for forming a metal-containing film satisfies 1.00 ≤ Mw/Mn ≤ 1.30, where Mw is a weight-average molecular weight and Mn is a number-average molecular weight measured by gel permeation chromatography in terms of polystyrene.

6. A composition for forming a metal-containing film, the composition functioning as a resist underlayer film material and/or a resist material used in manufacturing a semiconductor, the composition comprising: (A) the compound for forming a metal-containing film according to any one of claims 1 to 5; and (B) an organic solvent.

7. The composition for forming a metal-containing film according to claim 6, wherein the composition for forming a metal-containing film is usable as a resist underlayer film used in a multilayer resist method, the composition further comprising one or more of (C) a crosslinking agent, (D) a high-boiling-point solvent, (E) a surfactant, and (F) a flowability accelerator.

8. The composition for forming a metal-containing film according to claim 7, wherein the high-boiling-point solvent (D) is one or more kinds of organic solvent having a boiling point of 180°C or higher.

9. The composition for forming a metal-containing film according to any one of claims 6 to 8, further comprising (G) metal oxide nanoparticles having an average primary particle size of 100 nm or less; preferably wherein the metal oxide nanoparticles (G) are selected from the group consisting of zirconium oxide nanoparticles, hafnium oxide nanoparticles, titanium oxide nanoparticles, tin oxide nanoparticles, and tungsten oxide nanoparticles.

10. A patterning process for forming a pattern in a substrate to be processed, comprising the steps of:
(A)
(I-1) applying the composition for forming a metal-containing film according to any one of claims 6 to 9 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed; or
(B)
(II-1) applying the composition for forming a metal-containing film according to any one of claims 6 to 9 onto a substrate to be processed, followed by heating to form a metal-containing film;
(II-2) forming a resist middle layer film on the metal-containing film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the metal-containing film by dry etching while using the resist middle layer film having the transferred pattern as a mask; and
(II-7) processing the substrate to be processed while using the metal-containing film having the formed pattern as a mask to form the pattern in the substrate to be processed; or
(C)
(III-1) applying the composition for forming a metal-containing film according to any one of claims 6 to 9 onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed; or
(D)
(IV-1) forming a resist underlayer film on a substrate to be processed;
(IV-2) applying the composition for forming a metal-containing film according to any one of claims 6 to 9 onto the resist underlayer film, followed by heating to form a metal-containing film;
(IV-3) forming a resist upper layer film on the metal-containing film by using a photoresist material;
(IV-4) subjecting the resist upper layer film to pattern exposure and then development with a developer to form a pattern in the resist upper layer film;
(IV-5) transferring the pattern to the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed; or
(E)
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 6 to 9 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

11. The patterning process according to claim 10, embodiment (C), wherein the inorganic hard mask middle layer film is formed by a CVD method or an ALD method.

12. A patterning process comprising the steps of:
applying the composition for forming a metal-containing film according to any one of claims 6 to 9 onto a substrate, followed by heating to form a resist film;
exposing the resist film to a high-energy beam; and
developing the exposed resist film by using a developer.

13. The patterning process according to claim 12, wherein an organic solvent is used as the developer; preferably wherein the developer is one or more organic solvents selected from 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, pentyl acetate, butenyl acetate, isopentyl acetate, propyl formate, butyl formate, isobutyl formate, pentyl formate, isopentyl formate, methyl valerate, methyl pentenoate, methyl crotonate, ethyl crotonate, methyl lactate, ethyl lactate, propyl lactate, butyl lactate, isobutyl lactate, pentyl lactate, isopentyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.

14. The patterning process according to claim 12 or 13, wherein an extreme ultraviolet ray having a wavelength of 3 to 15 nm is used as the high-energy beam, or wherein an electron beam having an acceleration voltage of 1 to 250 kV is used as the high-energy beam.

15. A semiconductor photoresist material, wherein the semiconductor photoresist material is the composition for forming a metal-containing film according to any one of claims 6 to 9 further comprising (H) a photo-acid generator.
